# EUROPEAN PATENT APPLICATION

(11) **EP 4 852 663 A1**
(43) Date of publication of application: **09.12.2026**
(21) Application number: 25921564.8
(22) Date of filing: 28.09.2025
(51) Int. Cl.: H10F 19/90, H10F 77/20

(54) **BACK CONTACT CELL, CELL MODULE AND PHOTOVOLTAIC SYSTEM**

(30) Priority: 22.01.2025 CN 202510107200; 22.01.2025 CN 202510101742; 22.01.2025 CN 202510107379
(71) Applicant: Zhejiang Aiko Solar Technology Co., Ltd, Jinhua, Zhejiang 322009 (CN)
(72) Inventor: WANG, Yongqian, Jinhua, Zhejiang 322009 (CN); YANG, Xinqiang, Jinhua, Zhejiang 322009 (CN); CHEN, Gang, Jinhua, Zhejiang 322009 (CN)
(74) Representative: EP&C
(86) International application number: PCT/CN2025/124988
(87) International publication number: WO 2026/157315

(57) **Abstract**

The present application relates to the field of solar cell technology, and provides a back-contact cell (100), a cell assembly (200), and a photovoltaic system (1000). In the back-contact cell (100), a first collecting grid line (21) is discontinuous at a first edge interconnection region (131) and continuous at a second interconnection region (14), a first bus grid line (22) is continuous at the first edge interconnection region (131) and the second interconnection region (14), and a second grid line (30) is continuous at the first edge interconnection region (131). A first edge bus line (40) is closer to a first edge (121) than the first edge interconnection region (131), and the first edge bus line (40) is electrically connected to at least a portion of the first collecting grid line (21) and electrically connected to the first bus grid line (22). A first insulating layer (50) is disposed on a portion of the first bus grid line (22) corresponding to the first interconnection region (13).

## Description

### Cross-Reference to Related Application

The present application claims priority to Chinese Patent Application Nos. 202510107200.5, 202510101742.1, and 202510101743.6, filed with the China National Intellectual Property Administration on January 22, 2025, which are incorporated herein by reference in their entirety.

### Technical Field

The present application relates to the field of solar cell technology, and in particular, to a back-contact cell, a cell assembly, and a photovoltaic system.

### Background

A back-contact cell is a type of cell in which both a P-type doped layer and an N-type doped layer are disposed on a rear side of a silicon wafer, and no metal electrodes are disposed on a front side of the silicon wafer to cause shading. The back-contact cell exhibits higher short-circuit current and conversion efficiency.

In the related art, the rear side of a back-contact cell is provided with alternately arranged grid lines. To reduce the use of paste and transmission loss, the grid lines of the cells in a cell assembly can be directly electrically connected by solder ribbons to achieve current collection and output.

### Summary

The present application provides a back-contact cell, a cell assembly, and a photovoltaic system.

The present application is implemented as follows. A back-contact cell in an embodiment of the present application includes:
a substrate, where the substrate is provided with a front side and a rear side opposite to each other, the rear side is provided with a first edge and a second edge opposite to each other in a first direction, the rear side is provided with a plurality of first interconnection regions and a plurality of second interconnection regions, the first interconnection regions and the second interconnection regions are alternately arranged in the first direction, the plurality of first interconnection regions include a first edge interconnection region closest to the first edge, and no second interconnection region is provided between the first edge interconnection region and the first edge;
a plurality of first grid lines and a plurality of second grid lines alternately arranged on the rear side in a second direction, where the second direction intersects the first direction, all the first grid lines and all the second grid lines are arranged to intersect the first interconnection regions and the second interconnection regions, the plurality of first grid lines include a plurality of first collecting grid lines and at least one first bus grid line, the first collecting grid line is discontinuous at the first edge interconnection region and continuous at the second interconnection region, the first bus grid line is continuous at the first edge interconnection region and in the second interconnection region, and the second grid line is continuous at the first edge interconnection region;
a first edge bus line, where the first edge bus line is closer to the first edge relative to the first edge interconnection region, the first edge bus line is electrically connected to at least a portion of the first collecting grid lines and electrically connected to the first bus grid line; and
a first insulating layer, where the first insulating layer is disposed in the first edge interconnection region and located on the first bus grid line.

The present application further provides a cell assembly, where the cell assembly includes a plurality of the back-contact cells according to any one of the foregoing aspects.

The present application further provides a photovoltaic system, where the photovoltaic system includes the cell assembly described above.

### Brief Description of Drawings

FIG. 1 is a schematic diagram of modules of a photovoltaic system according to an embodiment of the present application;
FIG. 2 is a schematic diagram of modules of a cell assembly according to an embodiment of the present application;
FIG. 3 is a schematic plan structural diagram of a back-contact cell according to an embodiment of the present application;
FIG. 4 is a partial enlarged schematic diagram of the back-contact cell in FIG. 3 at IV;
FIG. 5 is a schematic diagram of a cross-sectional structure of the back-contact cell in FIG. 4 along line V-V;
FIG. 6 is a schematic diagram of a cross-sectional structure of the back-contact cell in FIG. 4 along line VI-VI;
FIG. 7 is a partial enlarged schematic diagram of the back-contact cell in FIG. 4 at VII;
FIG. 8 is a schematic diagram of another cross-sectional structure of the back-contact cell in FIG. 4 along line VI-VI;
FIG. 9 is a schematic diagram of yet another cross-sectional structure of the back-contact cell in FIG. 4 along line VI-VI;
FIG. 10 is a partial enlarged schematic diagram of the back-contact cell in FIG. 4 at VIII;
FIG. 11 is a partial enlarged schematic diagram of the back-contact cell in FIG. 4 at IX;
FIG. 12 is a partial enlarged schematic diagram of the back-contact cell in FIG. 3 at X;
FIG. 13 is a schematic diagram of a cross-sectional structure of the back-contact cell in FIG. 12 along line XI-XI;
FIG. 14 is a schematic diagram of a cross-sectional structure of the back-contact cell in FIG. 12 along line XII-XII;
FIG. 15 is a partial enlarged schematic diagram of the back-contact cell in FIG. 12 at XIII;
FIG. 16 is a schematic diagram of another cross-sectional structure of the back-contact cell in FIG. 12 along line XI-XI;
FIG. 17 is a schematic diagram of another cross-sectional structure of the back-contact cell in FIG. 12 along line XII-XII;
FIG. 18 is a partial enlarged schematic diagram of the back-contact cell in FIG. 12 at XIV;
FIG. 19 is a partial enlarged schematic diagram of the back-contact cell in FIG. 12 at XV; and
FIG. 20 is another schematic plan structural diagram of a back-contact cell according to an embodiment of the present application.

### Detailed Description of Embodiments

To make the object, technical solutions, and advantages of the present application clearer, the present application will be further described in detail with reference to the accompanying drawings and embodiments. The examples of embodiments are shown in the accompanying drawings, where the same or similar labels throughout represent the same or similar elements or the elements with the same or similar functions. It should be noted that embodiments described below with reference to the accompanying drawings are exemplary, which are only intended to explain the present application and cannot be understood as limiting the present application. In addition, it should be understood that the specific embodiments described here are intended for illustrating rather than limiting the present application.

In the descriptions of the present application, it should be understood that, the terms "top", "bottom", "left", "right", "transverse", "longitudinal", and the like indicate the orientation or position relationship based on the orientation or position relationship shown in the accompanying drawings, only for the convenience of simple description of the present application, rather than indicating or implying that the devices or elements referred to must have a specific orientation and must be constructed and operated in a specific orientation, and therefore cannot be understood as a limitation on the present application.

In addition, the terms like "first" and "second" are only for illustrative purposes and cannot be understood as indicating or implying relative importance or the number of technical features referred to. Therefore, the features defined with "first" and "second" may explicitly or implicitly include one or more features. In the descriptions of the present application, the meanings of "a plurality of" refer to two or more, unless otherwise specified.

In the present application, unless otherwise specified and limited, the first feature "above" or "below" the second feature may include direct contact between the first and second features, or direct contact between the first and second features through additional features therebetween. Moreover, the first feature "over", "above" and "on" the second feature includes the first feature being directly above and diagonally above the second feature, or simply indicates that the first feature is horizontally higher than the second feature. The first feature "below", "beneath", and "under" the second feature includes the first feature directly below and diagonally below the second feature, or simply indicates that the horizontal height of the first feature is less than that of the second feature.

The following disclosure provides many different embodiments or examples to implement different features in the present application. The components and arrangements of specific examples are described below to simplify the disclosure of the present application. These are, of course, merely examples and are not intended to limit the present application. In addition, the present application may repeat reference numerals and/or letters in the various examples. This repetition is for the purpose of simplicity and clarity and does not in itself dictate a relationship between the various embodiments and/or configurations discussed. In addition, the present application provides examples of various specific processes and materials, but those of ordinary skill in the art can be aware of the present application of other processes and/or the usage scenarios of other materials.

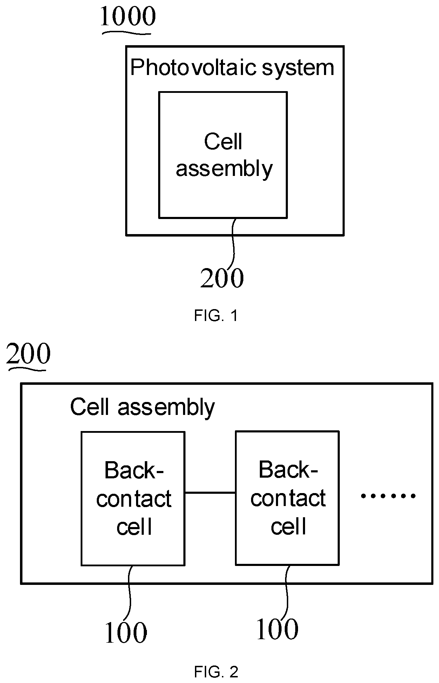

Referring to FIG. 1 and FIG. 2, a photovoltaic system 1000 in an embodiment of the present application may include a cell assembly 200 in an embodiment of the present application, where the cell assembly 200 may include a plurality of back-contact cells 100 in an embodiment of the present application. In an embodiment of the present application, a plurality of back-contact cells 100 in a cell assembly 200 may be interconnected to form a plurality of cell strings. The plurality of cell strings may be connected in series, parallel, or in series-parallel combinations to achieve current collection and output. For example, the cells may be connected by soldering solder ribbons, or the cell strings may be connected by busbars. In some embodiments, the cell strings may form cell arrays, and the cell arrays are packaged together through a front plate, a front adhesive film, a rear adhesive film, and a back plate to form the cell assembly 200.

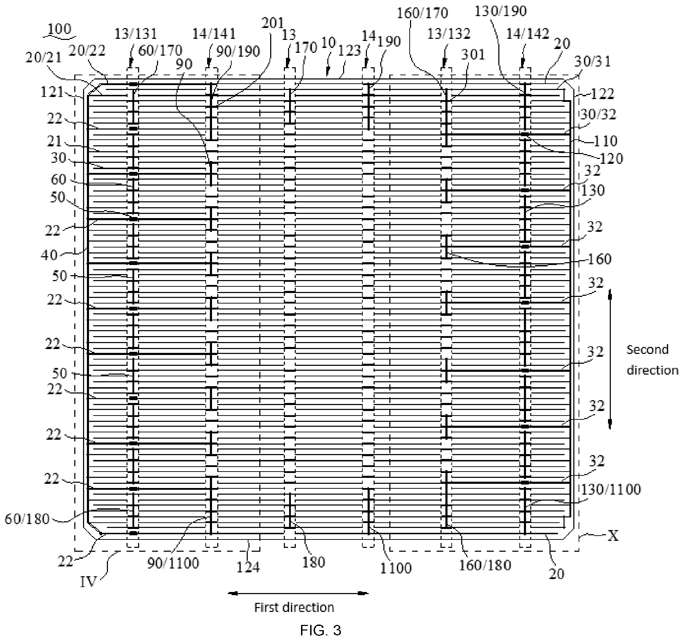

In an embodiment of the present application, the back-contact cell 100 may be a busbar-free back-contact cell. Referring to FIG. 3 to FIG. 6, the back-contact cell 100 in this embodiment of the present application may include a substrate 10, a plurality of first grid lines 20, a plurality of second grid lines 30, a first edge bus line 40, and a first insulating layer 50.

As shown in FIG. 3 to FIG. 9, the substrate 10 is provided with a front side 11 and a rear side 12 opposite to each other, the rear side 12 of the substrate 10 is provided with a first edge 121 and a second edge 122 opposite to each other in a first direction, and the rear side 12 is provided with a plurality of first interconnection regions 13 and a plurality of second interconnection regions 14. The first interconnection region 13 and the second interconnection region 14 are configured to receive a positive solder ribbon and a negative solder ribbon, respectively, that is, one of the first interconnection regions 13 and the second interconnection regions 14 is a positive interconnection region, and the other is a negative soldering region.

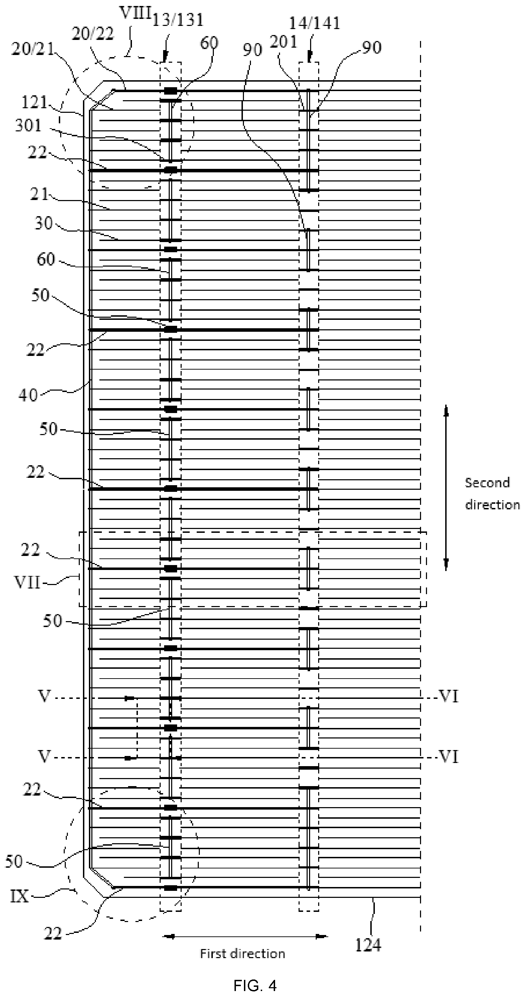

As shown in FIG. 3 and FIG. 4, the first interconnection regions 13 and the second interconnection regions 14 are alternately arranged in the first direction, the plurality of first interconnection regions 13 include a first edge interconnection region 131 closest to the first edge 121, and no second interconnection region 14 is provided between the first edge interconnection region 131 and the first edge 121. In other words, as shown in FIG. 3, among the first interconnection regions 13 and the second interconnection regions 14, an interconnection region closest to the first edge 121 is a first interconnection region 13, the first interconnection region 13 represents the first edge interconnection region 131, and no other interconnection region is provided between the first edge interconnection region 131 and the first edge 121.

As shown in FIG. 3, a plurality of first grid lines 20 and a plurality of second grid lines 30 are alternately arranged on the rear side 12 in a second direction, and the second direction intersects the first direction. All the first grid lines 20 and all the second grid lines 30 are arranged to intersect the first interconnection regions 13 and the second interconnection regions 14, that is, the first interconnection regions 13 and the second interconnection regions 14 extend along the second direction to intersect the first grid lines 20 and the second grid lines 30.

In some embodiments, the first direction and the second direction may be a longitudinal direction and a transverse direction of the back-contact cell 100, respectively. The first direction is perpendicular to the second direction. For example, in an example shown in FIG. 3, the first direction is the transverse direction of the back-contact cell 100, and the second direction is the longitudinal direction of the back-contact cell 100. Of course, in other embodiments, the first direction and the second direction may be other directions, for example, two diagonal directions of the back-contact cell 100. This is not specifically limited herein.

The plurality of first grid lines 20 may include a plurality of first collecting grid lines 21 and at least one first bus grid line 22, the first collecting grid line 21 is discontinuous at the first edge interconnection region 131 and continuous at the second interconnection region 14, the first bus grid line 22 is continuous at the first edge interconnection region 131 and in the second interconnection region 14, and the second grid line 30 is continuous at the first edge interconnection region 131.

That is, the first grid lines 20 include at least two types of grid lines: the first collecting grid line 21 and the first bus grid line 22. The first collecting grid line 21 is discontinuous at the first edge interconnection region 131, and the first bus grid line 22 is continuous at the first edge interconnection region 131. The second grid line 30 is also continuous at the first edge interconnection region 131. In the cell assembly 200, the solder ribbons in the first interconnection region 13 (including the first edge interconnection region 131) are configured to connect to the second grid lines 30 to achieve current collection and output of the second grid lines 30. The solder ribbons in the second interconnection region 14 are configured to solder to the first grid lines 20 to achieve current collection and output of the first grid lines 20.

As shown in FIG. 3, the first edge bus line 40 is closer to the first edge 121 than the first edge interconnection region 131. The first edge bus line 40 is electrically connected to at least a portion of the first collecting grid lines 21 and to the first bus grid line 22. Specifically, to avoid soldering at the edge position of the first edge 121, which may cause microcracks in the cell, the first edge bus line 40 is not used for soldering. The first edge bus line 40 is configured to collect current from a portion of the first collecting grid lines 21 located between the first edge interconnection region 131 and the first edge 121, and then conduct the current through the first bus grid line 22 to the same-polarity solder ribbons in the second interconnection region 14 adjacent to the first edge interconnection region 131 (i.e., the leftmost second interconnection region 14 in FIG. 3 and FIG. 4). In this way, the current in the grid line segments of the first grid lines 20 in the edge region at the first edge 121 is collected, thereby improving the efficiency of the back-contact cell 100. Without the first edge bus line 40 and the first bus grid line 22, the portion of the first grid lines 20 between the first edge interconnection region 131 and the first edge 121 would form isolated grid line segments, and consequently, the current in this portion cannot be collected.

As shown in FIG. 3, the first insulating layer 50 is disposed in the first edge interconnection region 131 and located on the first bus grid line 22. That is, the first insulating layer 50 is provided on the portion of the first bus grid line 22 corresponding to the first edge interconnection region 131. The first insulating layer 50 is configured to electrically insulate the opposite-polarity solder ribbons in the first edge interconnection region 131 from the first bus grid line 22 to prevent short circuits.

In the related art, the rear side of a back-contact cell is provided with alternately arranged grid lines. To reduce the use of paste and transmission loss, the grid lines of the cells in a cell assembly can be directly electrically connected by solder ribbons to achieve current collection and output. However, in such a technical solution, the performance of the back-contact cell still needs to be improved.

In the back-contact cell 100, the cell assembly 200, and the photovoltaic system 1000 according to an embodiment of the present application, the first collecting grid line 21 is discontinuous at the first edge interconnection region 131 and continuous at the second interconnection region 14, the first bus grid line 22 is continuous at both the first edge interconnection region 131 and the second interconnection region 14, and the second grid line 30 is continuous at the first edge interconnection region 131. The first edge bus line 40 is closer to the first edge 121 than the first edge interconnection region 131. The first edge bus line 40 is electrically connected to at least a portion of the first collecting grid lines 21 and to the first bus grid line 22. The first insulating layer 50 is provided on a portion of the first bus grid line 22 corresponding to the first interconnection region 13. In this way, by providing the first edge bus line 40 and the first bus grid line 22, the current collected from at least a portion of the isolated segments of the first grid lines 20 located between the first edge interconnection region 131 and the first edge 121 can be conducted to the same-polarity solder ribbons in the second interconnection region 14 adjacent to the first edge interconnection region 131. This arrangement effectively avoids soldering at the first edge 121 of the back-contact cell 100, which could cause microcracks, and ensures the efficiency of the back-contact cell 100. The provision of the first insulating layer 50 electrically isolates the first bus grid line 22 from the opposite-polarity solder ribbons in the first edge interconnection region 131, thereby preventing short circuits and leakage that could affect the performance of the back-contact cell 100.

It is readily understood that, in the present application, the first edge bus line 40 is not used for soldering, but only for current transmission and collection, and the first bus grid lines 22 function to collect and transmit current. It can be seen from FIG. 3 and FIG. 4 that, in the examples shown in FIG. 3 and FIG. 4, without the first edge bus line 40 and the first bus grid line 22, the first grid line 20 is discontinuous at the first edge interconnection region 131, and the current in a portion of the grid line segment of the first grid line 20 located between the first edge interconnection region 131 and the first edge 121 cannot be collected. Therefore, by providing the first edge bus line 40 and the first bus grid line 22, the current of at least a portion of the isolated grid line segments of the first grid lines 20 in this edge region can be transmitted to the solder ribbons in the adjacent second interconnection region 14, thereby effectively preventing efficiency loss.

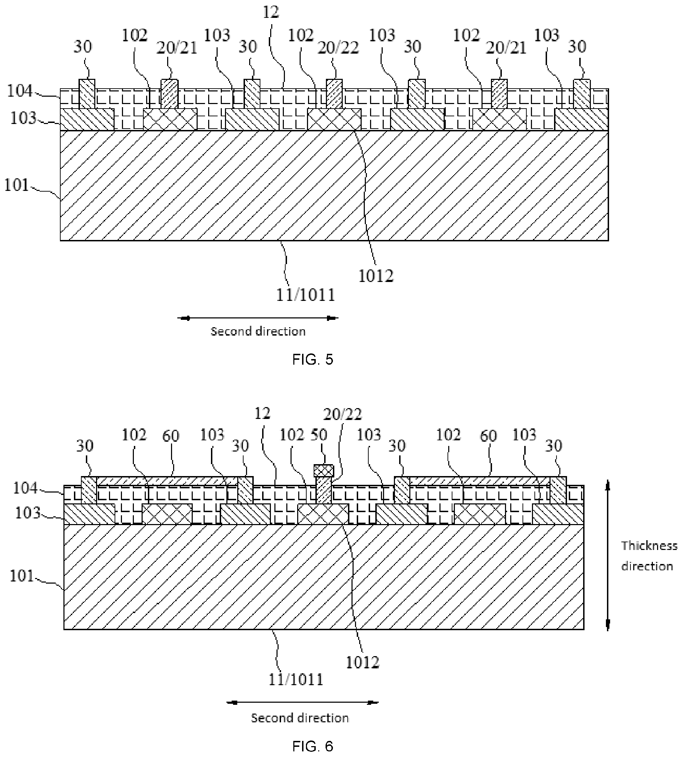

Referring to FIG. 3 to FIG. 6, in some embodiments, the back-contact cell 100 may further include a first auxiliary connecting line 60. The first auxiliary connecting line 60 may be disposed in the first edge interconnection region 131. In the second direction, at least one side of the first bus grid line 22 is provided with the first auxiliary connecting line 60. The first auxiliary connecting line 60 is configured to connect at least two second grid lines 30 located on the same side of the first bus grid line 22. As shown in FIG. 4 and FIG. 6, in some embodiments, the at least two second grid lines 30 connected to the first auxiliary connecting line 60 preferably include the second grid line 30 adjacent to the first bus grid line 22 (i.e., the second grid line 30 closest to the first bus grid line 22 in FIG. 3 and FIG. 4). That is, in some embodiments, the first auxiliary connecting line 60 is preferably connected to the second grid line 30 closest to the first bus grid line 22, and the first auxiliary connecting line 60 is further connected to at least one of the remaining second grid lines 30 located on the same side as the second grid line 30. That is, the first auxiliary connecting line 60 is preferably connected to at least the second grid line 30 adjacent to the first bus grid line 22 and at least one of the remaining second grid lines 30 on the same side.

In this way, by providing the first auxiliary connecting line 60, even if a second grid line 30 near the first insulating layer 50 is poorly soldered to the solder ribbon due to the provision of the first insulating layer 50, with the provision of the first auxiliary connecting line 60, the second grid line 30 with poor soldering can still achieve current collection and output through the first auxiliary connecting line 60. This reduces the effect caused by poor soldering, thereby ensuring the efficiency of the back-contact cell 100.

It can be understood that, due to the continuous arrangement of the first bus grid line 22 in the first edge interconnection region 131, the first insulating layer 50 (e.g., insulating adhesive) needs to be provided at the portion of the first bus grid line 22 corresponding to the first edge interconnection region 131 to prevent the solder ribbons in the first edge interconnection region 131 from contacting the first bus grid line 22 and causing short circuits. The height of the first insulating layer 50 is greater than that of the second grid lines 30; that is, in the thickness direction, the protruding height of the first insulating layer 50 is greater than the height of the second grid lines 30. In this case, the solder ribbons in the first edge interconnection region 131 are prone to poor soldering with the second grid lines 30 during the soldering process, which can result in ineffective current collection from some second grid lines 30 (particularly the second grid line 30 adjacent to the first bus grid line 22, which has the highest possibility of poor soldering). Based on this, the present application provides the first auxiliary connecting line 60 to connect at least two second grid lines 30 on the same side of the first bus grid line 22, preferably including the second grid line 30 adjacent to the first bus grid line 22. The first auxiliary connecting line 60 can integrate a portion of the second grid lines 30 into a single electrical network. Even if one of the second grid lines 30 experiences poor soldering due to the presence of the first insulating layer 50, current can still be output through the first auxiliary connecting line 60, thereby reducing or even completely eliminating the effect caused by poor soldering.

Further, in an embodiment of the present application, as shown in FIG. 5 and FIG. 6, the substrate 10 may include a silicon substrate 101, a plurality of first doped layers 102, a plurality of second doped layers 103, and a rear passivation layer 104. The silicon substrate 101 is provided with a first surface 1011 and a second surface 1012 opposite to each other. The first doped layers 102 and the second doped layers 103 are both disposed on the second surface 1012, and the plurality of first doped layers 102 and the plurality of second doped layers 103 are alternately arranged along the second direction. The rear passivation layer 104 is at least stacked on the first doped layers 102 and the second doped layers 103. In some embodiments, the rear passivation layer 104 may cover the entire second surface 1012. That is, the rear passivation layer 104 is stacked on the first doped layers 102, the second doped layers 103, and a region of the second surface 1012 that is not provided with doped layers.

It can be seen that the side of the substrate 10 where the first surface 1011 is located is the front side 11 of the substrate 10, and the side where the second surface 1012 is located is the rear side of the substrate 10. Of course, in some embodiments, a first passivation layer (not shown) may also be provided between the first doped layer 102 and the silicon substrate 101 in the substrate 10. For example, the first passivation layer may be a tunnel layer, an intrinsic amorphous silicon layer, or the like. A second passivation layer (not shown) may also be provided between the second doped layer 103 and the silicon substrate 101. For example, the second passivation layer may be a tunnel layer, an intrinsic amorphous silicon layer, or the like.

In the back-contact cell 100, the first grid lines 20 correspond one-to-one with the first doped layers 102, and the second grid lines 30 correspond one-to-one with the second doped layers 103. One of the first doped layer 102 and the second doped layer 103 may be a P-type doped layer, and the other may be an N-type doped layer. In some embodiments, the first grid lines 20 may fully penetrate the rear passivation layer 104 to form full contact with the first doped layers 102, or the first grid lines 20 may only partially penetrate the rear passivation layer 104 to form local metallization contacts with the first doped layers 102. This is not specifically limited herein.

That is, in an embodiment of the present application, the first grid lines 20 are disposed corresponding to the first doped layers 102 and are in conductive contact with the first doped layers 102 by at least partially penetrating the rear passivation layer 104, and the second grid lines 30 are disposed corresponding to the second doped layers 103 and are in conductive contact with the second doped layers 103 by at least partially penetrating the rear passivation layer 104.

Referring to FIG. 3, in some embodiments, the back-contact cell 100 may be a busbar-free back-contact cell. Among the plurality of first grid lines 20, the first collecting grid lines 21 are discontinuous at the first interconnection region 13 and continuous at the second interconnection region 14. The first bus grid lines 22 are continuous at the first edge interconnection region 131 and discontinuous at the remaining portions of the first interconnection region 13, and are continuous at the second interconnection region 14.

As shown in FIG. 3, FIG. 4, and FIG. 7, in some embodiments, the first grid lines 20 (including the first collecting grid line 21 and the first bus grid line 22) may include first soldering segments 201 disposed in the second interconnection region 14 corresponding to the second interconnection region 14. That is, the first grid lines 20 are continuous at each second interconnection region 14 and have first soldering segments 201 in the second interconnection region 14 for soldering to solder ribbons. The second grid lines 30 (including the second collecting grid lines 31 and the second bus grid lines 32) may include second soldering segments 301 disposed in the first interconnection region 13 (including the first edge interconnection region 131) corresponding to the first interconnection region 13. That is, the second grid lines 30 are continuous at each first interconnection region 13 and have second soldering segments 301 in the first interconnection region 13 for soldering to solder ribbons.

In some embodiments, in the first collecting grid line 21, the width of the first soldering segments 201 (i.e., the length in the second direction) may be greater than the width of the remaining portions. In this way, the contact area between the first collecting grid lines 21 and the solder ribbons can be increased, thereby improving the stability of soldering.

In some embodiments, the first soldering segment 201 may have a double-layer structure. Specifically, in some embodiments, the first grid lines 20 may include a first collecting layer (not shown) penetrating the rear passivation layer 104 and a first soldering layer (not shown) stacked on the first collecting layer and not penetrating the rear passivation layer 104.

In some embodiments, the first collecting layer may be continuous at the second interconnection region 14 and discontinuous at the first interconnection region 13. The first soldering layer may be disposed in the second interconnection region 14 and located on the first collecting layer. In this case, the portions of the first grid lines 20 corresponding to the first soldering layer are the first soldering segments 201.

Of course, in other embodiments, the first soldering segments 201 may have a single-layer structure. In this case, the first collecting layer is discontinuous at both the second interconnection region 14 and the first interconnection region 13, and the first soldering layer is disposed in the second interconnection region 14 and electrically connected to two ends of the first collecting layer in the second interconnection region 14. It is readily understood that, in these cases, the portions corresponding to the first soldering layer are the first soldering segments 201.

In some embodiments, the width of the first soldering layer may be set greater than the width of the first collecting layer, where the width refers to the length of the first soldering layer and the first collecting layer in the second direction. In this way, the contact area during soldering can be increased, and the reliability of soldering is improved.

In some embodiments, the second soldering segments 301 may also have a double-layer structure. Specifically, in some embodiments, the second grid lines 30 may include a second collecting layer penetrating the rear passivation layer 104 and a second soldering layer stacked on the second collecting layer and not penetrating the rear passivation layer 104.

In some embodiments, the second collecting layer may be continuous at the first interconnection region 13 and discontinuous at the second interconnection region 14. The second soldering layer may be disposed in the first interconnection region 13 and located on the second collecting layer. In this case, the portions of the second grid lines 30 corresponding to the second soldering layer are the second soldering segments 301.

Of course, in other embodiments, the second collecting layer may be discontinuous at both the first interconnection region 13 and the second interconnection region 14. The second soldering layer is disposed in the first interconnection region 13 and electrically connected to the two ends of the second collecting layer in the first interconnection region 13. It is readily understood that, in these cases, the portions corresponding to the second soldering layer are the second soldering segments 301.

In some embodiments, the width of the second soldering layer may also be set greater than the width of the second collecting layer, where the width refers to the length of the first soldering layer and the first collecting layer in the second direction.

As shown in FIG. 3 and FIG. 4, in an embodiment of the present application, to minimize the effect of poor soldering, when the second grid lines 30 are provided on two sides of the first bus grid line 22, first auxiliary connecting lines 60 are preferably provided on both sides of the first bus grid line 22 simultaneously.

In some embodiments, the width of the first bus grid line 22 (i.e., the length in the second direction) may be greater than the width of the portions of the first collecting grid lines 21 located outside the second interconnection region 14 (i.e., the portions of the first collecting grid lines 21 excluding the first soldering segments 201) (i.e., the length in the second direction).

In this way, since the first bus grid line 22 needs to perform the function of current collection and transmission, increasing the width of the first bus grid line 22 can reduce transmission loss during current collection process, thereby improving efficiency.

In addition, as shown in FIG. 3, FIG. 4, and FIG. 7, in an embodiment of the present application, the first bus grid lines 22 are continuous only in the first edge interconnection region 131 and are discontinuous at the other portions of the first interconnection region 13. Meanwhile, the first bus grid lines 22 are continuous at the second interconnection region 14 and have first soldering segments 201 in the second interconnection region 14. Only the portion of the first bus grid lines 22 closest to the first edge 121 performs the current collection function. Therefore, in some embodiments, to save paste to reduce cost, only the portion of the grid line segments may be configured to have a greater width. In this case, referring to FIG. 3, FIG. 4, and FIG. 7, the plurality of second interconnection regions 14 may include a second edge interconnection region 141 closest to the first edge 121. The first bus grid lines 22 may include a first bus segment 221 located between the second edge interconnection region 141 and the first edge 121. In some embodiments, the width of the first bus segment 221 (i.e., the length in the second direction) may be greater than the width of the part in the remaining portion of the first bus grid lines 22 located outside the second interconnection region 14 (i.e., a portion other than the first bus segment 221 excluding the first soldering segments 201).

In this way, by configuring only the first bus segment 221 to have a greater width, transmission loss during current collection can be reduced, and the use of paste is decreased, thereby lowering costs.

Specifically, as described above, in such embodiments, the first bus grid lines 22 are continuous at the second edge interconnection region 141 and have first soldering segments 201 in the second edge interconnection region 141. The first bus segment 221 can collect current and conduct the current to the solder ribbons disposed in the second edge interconnection region 141, and configuring only a portion of the first bus segment 221 to have a greater width can reduce the use of paste. In this case, the first bus segment 221 penetrates the rear passivation layer 104 and is in contact with the first doped layers 102.

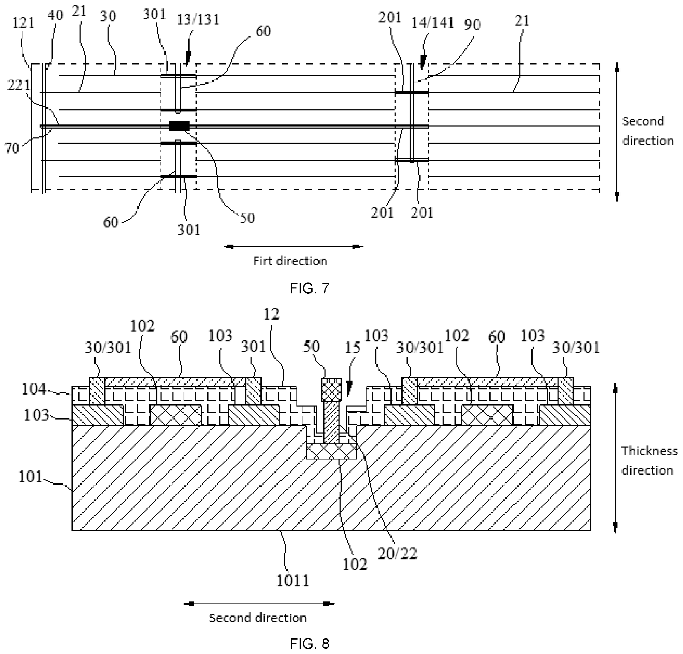

Referring to FIG. 7, in some other embodiments, a first current-collecting layer 70 may be disposed on the first bus segment 221. In this way, by providing the first current-collecting layer 70 on the first bus segment 221, the cross-sectional area of the first bus segment 221 is effectively increased, which can likewise reduce transmission loss. Meanwhile, the first current-collecting layer 70 may be formed using a paste having a lower cost than that of the first bus segment 221, thereby reducing cost.

Specifically, in such embodiments, the first current-collecting layer 70 may be made of a non-fire-through paste. The first current-collecting layer 70 does not penetrate the rear passivation layer 104 to contact the first doped layer 102, and the paste cost of the first current-collecting layer 70 is lower than that of the first bus segment 221. It can be understood that, since the first current-collecting layer 70 is disposed on the first bus segment 221, there may be no need to widen the first bus segment 221, and transmission loss reduction can still be achieved.

Further, in such embodiments, the width of the first current-collecting layer 70 (i.e., the length in the second direction) may be greater than the width of the portions of the first collecting grid lines 21 located outside the second interconnection region 14 (i.e., the portions of the first collecting grid lines 21 excluding the first soldering segments 201). In this manner, by increasing the width of the first current-collecting layer 70, the current transmission capability can be further enhanced, and transmission loss can be reduced.

Specifically, in such embodiments, the width of the first current-collecting layer 70 may be the same as the width of the first soldering segment 201. Herein, the width of the first soldering segment 201 refers to the length of the first soldering segment 201 in the second direction. As described above, when the width of the first soldering layer is greater than that of the first collecting layer, the width of the first soldering segment 201 corresponds to the width of the first soldering layer (i.e., the length in the second direction). Similar descriptions appearing hereinafter may be understood with reference to this explanation.

In this way, no substantial transmission loss occurs during the current collection process. Meanwhile, during the printing process, the first current-collecting layer 70 may be printed simultaneously with the first soldering layer at the first soldering segment 201. When the same screen is used for printing, there is no need to provide screen openings of different sizes on the screen plate, thereby simplifying the manufacturing process and reducing manufacturing difficulty.

Referring to FIG. 7, in some embodiments, the width of the first edge bus line 40 (i.e., the length in the first direction) may be greater than the width of the portions of the first collecting grid lines 21 located outside the second interconnection region 14 (i.e., the portions of the first collecting grid lines 21 excluding the first soldering segments 201) (i.e., the length in the second direction).

In this way, since the first edge bus line 40 needs to perform the function of current collection and transmission, increasing the width of the first edge bus line 40 can also reduce transmission loss during current collection process, thereby improving efficiency.

Specifically, in such embodiments, the width of the first edge bus line 40 may be the same as the width of the first soldering segment 201. In this way, no substantial current collection loss occurs during the current-collecting process. Meanwhile, during printing, the first edge bus line 40, the first collecting grid lines 21, and the first soldering segments 201 may be printed simultaneously using the same screen plate openings, thereby effectively saving manufacturing steps and reducing manufacturing difficulty.

In addition, referring to FIG. 7, in some embodiments, the width of the first auxiliary connecting line 60 (i.e., the length in the first direction) is greater than the width of the portions of the first collecting grid lines 21 located outside the second interconnection region 14 (i.e., the portions of the first collecting grid lines 21 excluding the first soldering segments 201) (i.e., the length in the second direction).

In this way, since the first auxiliary connecting line 60 serves to transmit and collect current when poor soldering occurs, increasing the width of the first auxiliary connecting line 60 can also reduce transmission loss during current collection process, thereby improving efficiency.

In some embodiments, the width of the first auxiliary connecting line 60 may be the same as that of the first edge bus line 40.

Referring to FIG. 3 and FIG. 4, in some embodiments, the first edge bus line 40 is electrically connected to all the first collecting grid lines 21.

In this way, the current collected by all isolated grid line segments of the first collecting grid lines 21 located between the first edge interconnection region 131 and the first edge 121 can be collected, thereby maximizing the efficiency of the back-contact cell 100.

Of course, in some embodiments, the first edge bus line 40 may also be electrically connected to only a portion of the first collecting grid lines 21. In this case, the number of first collecting grid lines 21 not electrically connected to the first edge bus line 40 is less than or equal to 4. In this way, the small number of first collecting grid lines 21 not connected to the first edge bus line 40 does not cause significant efficiency loss or result in product defects.

In some embodiments, the first auxiliary connecting line 60 is connected to 2-20 second grid lines 30. In this way, setting the number of second grid lines 30 connected to the first auxiliary connecting line 60 within this reasonable range can minimize or even eliminate the effect caused by poor soldering.

In an embodiment of the present application, one first bus grid line 22 may be provided. In this case, the first auxiliary connecting line 60 may be provided on only one side of the first bus grid line 22, or the first auxiliary connecting line 60 is provided on two sides of the first bus grid line 22. This is not specifically limited herein. When the second grid lines 30 are provided on two sides of the first bus grid line 22, the first auxiliary connecting line 60 is preferably provided on two sides.

In addition, it should be noted that, in the present application, when a plurality of first bus grid lines 22 are provided, the first auxiliary connecting line 60 may be provided on only one side or on two sides of some first bus grid lines 22, and the first auxiliary connecting lines 60 may be not provided at the two sides of the remaining first bus grid lines 22. In this case, poor soldering at certain positions can still be resolved. In the present application, two sides of each first bus grid line 22 are preferably provided with first auxiliary connecting lines 60. Of course, when first bus grid line 22 is located at a third edge 123, one side of the first bus grid line 22 is provided with a first auxiliary connecting line 60.

Of course, referring to FIG. 3 and FIG. 4, in some embodiments, a plurality of first bus grid lines 22 may be provided. With the provision of the plurality of first bus grid lines 22, a current collection path is shortened, transmission loss during current collection is effectively reduced, and the efficiency is improved.

In this case, a first auxiliary connecting line 60 is provided between each two adjacent first bus grid lines 22, and the first auxiliary connecting line 60 located between two adjacent first bus grid lines 22 is connected to all the second grid lines 30 located between the two adjacent first bus grid lines 22.

In this way, the first auxiliary connecting line 60 is connected to all the second grid lines 30 between two adjacent first bus grid lines 22, so that the effect caused by poor soldering is substantially eliminated, and the efficiency of the back-contact cell 100 is improved as much as possible.

Specifically, in such embodiments, the number of first bus grid lines 22 in the back-contact cell 100 may be selected according to an actual condition, including a size of a cell and a loss during a transmission process. This is not specifically limited herein.

Referring to FIG. 3, FIG. 4, FIG. 10, and FIG. 11, in some embodiments, a plurality of first bus grid lines 22 are provided, and the substrate 10 is provided with a third edge 123 and a fourth edge 124 in a second direction. Among the first grid lines 20 and the second grid lines 30, a grid line closest to the third edge 123 is the first bus grid line 22, and/or a grid line closest to the fourth edge 124 is the first bus grid line 22.

In this way, the grid lines located at the third edge 123 and/or the fourth edge 124 are configured as the first bus grid lines 22, so that the current collection is achieved at an edge position, and the effect caused by poor soldering is reduced.

Specifically, as shown in FIG. 3 and FIG. 4, in such embodiments, in addition to the first bus grid lines 22 located at the third edge 123 and/or the fourth edge 124, a plurality of first bus grid lines 22 may further be provided in an intermediate region, a first auxiliary connecting line 60 is provided between each two adjacent first bus grid lines 22, and the first auxiliary connecting line 60 is connected to all the second grid lines 30 between the two adjacent first bus grid lines 22. In this way, the effect caused by poor soldering is substantially eliminated, and the efficiency of the back-contact cell 100 is ensured to the greatest extent.

Of course, it can be understood that, in some embodiments, among the first grid lines 20 and the second grid lines 30, a grid line closest to the third edge 123 may also be a first collecting grid line 21. In this case, the first auxiliary connecting line 60 between the first bus grid line 22 closest to the third edge 123 and the third edge 123 is connected to all the second grid lines 30 between the first bus grid line 22 closest to the third edge 123 and the third edge 123. That is, the first bus grid line 22 closest to the third edge 123 in FIG. 3 and FIG. 4 is replaced with the first collecting grid line 21.

In some embodiments, among the first grid lines 20 and the second grid lines 30, a grid line closest to the fourth edge 124 may also be a first collecting grid line 21, and the first auxiliary connecting line 60 between the first bus grid line 22 closest to the fourth edge 124 and the fourth edge 124 is connected to all the second grid lines 30 between the first bus grid line 22 closest to the fourth edge 124 and the fourth edge 124. That is, the first bus grid line 22 closest to the third edge 123 in FIG. 3 and FIG. 4 is replaced with the first collecting grid line 21.

In this way, the grid lines closest to the third edge 123 and/or the fourth edge 124 are configured as the first collecting grid lines 21, and the first bus grid lines 22 are only provided in the intermediate region, so that the first insulating layer 50 is not required to be provided at the third edge 123 and the fourth edge 124, the usage of insulating adhesive is reduced, and the cost is lowered. Meanwhile, in this case, the effect caused by poor soldering due to the first insulating layer 50 is substantially eliminated by configuring the first auxiliary connecting line 60 between the first bus grid line 22 closest to the third edge 123 and the third edge 123 in the foregoing connection manner.

Chinese Patent Application No. 202510101742.1:
Referring to FIG. 7 and FIG. 8, in some embodiments, the first grid line 20 may include a first soldering segment 201 corresponding to the second interconnection region 14, and the second grid line 30 may include a second soldering segment 301 corresponding to the first edge interconnection region 131. Specifically, the first grid line 20 (including the first collecting grid line 21 and the first bus grid line 22 described below) includes the first soldering segment 201 located in the second interconnection region 14. That is, the first grid line 20 is continuous at each second interconnection region 14 and is provided with the first soldering segment 201 at the second interconnection region 14 for soldering with a solder ribbon. The second grid line 30 (including the second collecting grid line 31 and the second bus grid line 32 described below) includes the second soldering segment 301 located in the first interconnection region 13 (including the first edge interconnection region 131). That is, the second grid line 30 is continuous at each first interconnection region 13 and is provided with the second soldering segment 301 at the first interconnection region 13 for soldering with a solder ribbon.

In some embodiments, a first recess 15 is formed on the substrate 10 in the first edge interconnection region 131, and a portion of the first bus grid line 22 is located in the first recess 15. In some possible embodiments, in the second direction, the first bus grid line 22 may extend along one side wall of the first recess 15 to a bottom of the first recess 15 and extend out from another side wall of the first recess 15 to a region outside the first recess 15.

A portion of the first bus grid line 22 corresponding to the first recess 15 does not fill the entire first recess 15. That is, in a thickness direction of the back-contact cell 100, a height of the portion of the first bus grid line 22 corresponding to the first recess 15 is less than a height of an opening of the first recess 15.

As shown in FIG. 8, the first insulating layer 50 is provided at the first recess 15 in the first edge interconnection region 131, and the first insulating layer 50 is at least partially disposed in the first recess 15 and located on the first bus grid line 22. That is, the first insulating layer 50 is provided on a portion of the first bus grid line 22 located in the first recess 15, the first insulating layer 50 is at least partially located in the first recess 15, and the first insulating layer 50 is configured to insulate an opposite-polarity solder ribbon in the first edge interconnection region 131 from the first bus grid line 22 to avoid short circuits.

In a thickness direction of the back-contact cell 100 (that is, in a direction from the front side 11 toward the rear side 12), a height of the first insulating layer 50 is flush with a height of the second soldering segment 301, or the height of the first insulating layer 50 is less than the height of the second soldering segment 301, or the height of the first insulating layer 50 is greater than the height of the second soldering segment 301, and a height difference between the first insulating layer 50 and the second soldering segment 301 is less than or equal to 15 µm.

In this way, the first recess 15 is formed on the substrate 10, and the first insulating layer 50 is at least partially provided in the first recess 15, so that the height of the first insulating layer 50 is less than the height of the second soldering segment 301, the height of the first insulating layer 50 is flush with the height of the second soldering segment 301, or the height of the first insulating layer 50 is greater than the height of the second soldering segment 301, and the height difference between the first insulating layer 50 and the second soldering segment 301 is less than or equal to 15 µm. Therefore, the insulation between the solder ribbon and the first bus grid line 22 is achieved, and a height difference between the first insulating layer 50 and the grid line soldering segment is reduced or even eliminated, thereby reducing a risk of poor soldering caused by the first insulating layer 50, reducing the impact of poor soldering on the back-contact cell 100, and improving performance of the back-contact cell 100.

It is readily understood that, due to continuous arrangement of the first bus grid line 22 in the first edge interconnection region 131, to avoid contact between a solder ribbon on the first edge interconnection region 131 and the first bus grid line 22 that would cause short circuits, the first insulating layer 50 (for example, insulating adhesive) needs to be provided at a position of the first bus grid line 22 corresponding to the first edge interconnection region 131. However, in this case, when the first recess 15 is not formed, a height of the first insulating layer 50 is greater than a height of the second soldering segment 301 of the second grid line 30. That is, in the thickness direction, a protruding height of the first insulating layer 50 is greater than a height of the second soldering segment 301 of the second grid line 30. In this case, the solder ribbon in the first edge interconnection region 131 is prone to poor soldering with the second grid line 30 during a soldering process, resulting in the current on a portion of the second grid line 30 not being effectively collected (especially for second grid lines 30 adjacent to the first bus grid line 22, which have the highest possibility of poor soldering). Based on this, the present application provides the first recess 15 on the substrate 10 and disposes at least a portion of the first insulating layer 50 in the first recess 15, so that the height of the first insulating layer 50 is flush with the height of the second soldering segment 301 or less than the height of the second soldering segment 301, or the height difference between the first insulating layer 50 and the second soldering segment 301 is less than or equal to 15 µm. In this way, a risk of poor soldering is reduced or even eliminated, the soldering reliability is improved, and the performance of the back-contact cell 100 is ensured.

Further, in some embodiments, a plurality of first bus grid lines 22 may be provided, the number of the first insulating layers 50 corresponds to the number of first bus grid lines 22, and the number of the first recesses 15 may correspond to the number of the first insulating layers 50. In this way, a risk of poor soldering caused by all the first insulating layers 50 is reduced or even eliminated.

Of course, in some possible embodiments, the first recess 15 is provided corresponding to only some of the first bus grid lines 22. That is, the first recess 15 is formed below only some of the first insulating layers 50, and no first recess 15 is formed at other positions. In this case, the poor soldering caused by some of the first insulating layers 50 is solved.

In a case where the height of the first insulating layer 50 is greater than the height of the second soldering segment 301, the height difference between the first insulating layer 50 and the second soldering segment 301 may be 1 µm, 2 µm, 3 µm, 4 µm, 5 µm, 9 µm, 7 µm, 8 µm, 9 µm, 10 µm, 11 µm, 12 µm, 13 µm, 14 µm, 15 µm, or any value within a range of 0-15 µm.

In some embodiments, in a case where the height of the first insulating layer 50 is greater than the height of the second soldering segment 301, the height difference between the first insulating layer 50 and the second soldering segment 301 is preferably less than 8 µm, for example, 0.5 µm, 1 µm, 2 µm, 3 µm, 4 µm, 5 µm, 9 µm, 7 µm, or 8 µm. Specifically, through repeated research and verification by inventors of the present application, it is found that a risk of poor soldering caused by the first insulating layer 50 is substantially eliminated by preferably setting the height difference between the first insulating layer 50 and the second soldering segment 301 within a range less than 8 µm.

In some embodiments, a recessed depth of the first recess 15 is less than one-half of a thickness of the substrate 10. Specifically, the term "recessed depth" refers to a distance between a bottom surface of the first recess 15 and an outermost surface of the rear passivation layer 104 facing away from the rear side 12 in the thickness direction, that is, a distance between the bottom surface of the first recess 15 and the rear side 12 of the substrate 10.

In this way, by setting the depth of the first recess 15 within this reasonable range, a risk of poor soldering caused by the first insulating layer 50 is reduced or even eliminated, and a reduction in strength of the back-contact cell 100 caused by an excessively large recessed depth is avoided.

Specifically, in this case, a recessed depth of the first recess 15 may be, for example, one-third, one-fourth, or one-fifth of a thickness of the substrate 10.

In some embodiments, the first recess 15 may penetrate the rear passivation layer 104 and the first doped layer 102, so that the silicon substrate 101 is exposed at the first recess 15, and a portion of the first bus grid line 22 located in the first recess 15 is in contact with the silicon substrate 101. In this way, after the substrate 10 is fabricated, the first recess 15 may be directly formed on the substrate 10 by etching (for example, laser etching) without inserting an etching or grooving process during fabrication of the substrate 10.

Specifically, in this case, a complete substrate 10 is first provided, a grooving process is directly performed at a position on the substrate 10 where the first insulating layer 50 needs to be provided, the first grid line 20 and the second grid line 30 are then printed, and the first insulating layer 50 is provided at the first recess 15.

Of course, in some other embodiments, at a position of the first bus grid line 22 corresponding to the first edge interconnection region 131, a first recessed groove is formed on the silicon substrate 101, and both the first doped layer 102 and the rear passivation layer 104 are recessed toward a side facing the front side 11 at the first recessed groove, thereby forming the first recess 15 on the substrate 10.

Specifically, in this case, during the fabrication process, before forming the first doped layer 102, a first recessed groove is first formed in the silicon substrate 101 at a position where the first doped layer 102 needs to be formed and the first insulating layer 50 needs to be provided. The first doped layer 102 and the rear passivation layer 104 are then formed to fabricate the substrate 10. Due to the formation of the first recessed groove on the silicon substrate 101, the first recess 15 described above is correspondingly formed on the substrate 10. The first grid line 20 and the second grid line 30 are then printed, and the first insulating layer 50 is provided at the first recess 15.

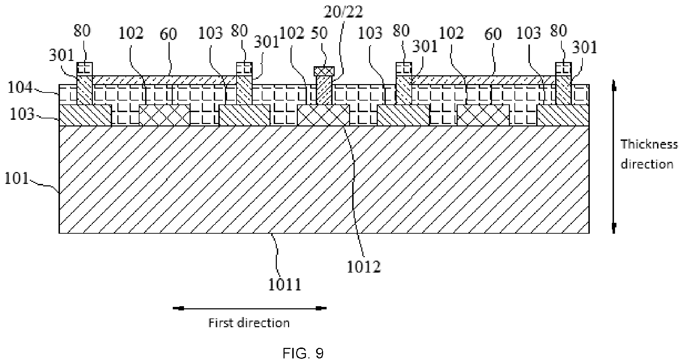

Chinese Patent Application No. 202510107379.4:
With reference to FIG. 9, in some embodiments, the back-contact cell 100 may further include a first auxiliary connecting layer 80. At the first edge interconnection region 131, the first auxiliary connecting layer 80 may be provided on the second grid line 30, that is, the first auxiliary connecting layer 80 may be provided on a portion of the second grid line 30 located in the first edge interconnection region 131. The first auxiliary connecting layer 80 is configured to solder with a solder ribbon. In a thickness direction of the back-contact cell 100, the first insulating layer 50 is flush with the first auxiliary connecting layer 80, or a height of the first insulating layer 50 is less than a height of the first auxiliary connecting layer 80, or a height difference between the first insulating layer 50 and the first auxiliary connecting layer 80 is less than or equal to 15 µm.

In this way, by providing the first auxiliary connecting layer 80 on a portion of the second grid line 30 corresponding to the first edge interconnection region 131, the height of the first insulating layer 50 is less than the height of the first auxiliary connecting layer 80, or the first insulating layer 50 is flush with the first auxiliary connecting layer 80, or the height of the first insulating layer 50 is greater than the height of the first auxiliary connecting layer 80, and a height difference between the first insulating layer 50 and the first auxiliary connecting layer 80 is less than or equal to 15 µm, thereby reducing or even eliminating poor soldering caused by provision of the first insulating layer 50, reducing the impact of poor soldering on the back-contact cell 100, and improving performance and efficiency of the back-contact cell 100.

It is readily understood that, due to continuous arrangement of the first bus grid line 22 in the first edge interconnection region 131, to avoid contact between a solder ribbon on the first edge interconnection region 131 and the first bus grid line 22 that would cause short circuits, the first insulating layer 50 (for example, insulating adhesive) needs to be provided at a position of the first bus grid line 22 corresponding to the first edge interconnection region 131. However, in this case, when the first auxiliary connecting layer 80 is not provided, a height of the first insulating layer 50 is greater than a height of a portion of the second grid line 30 located in the first edge interconnection region 131, that is, in a thickness direction, a protruding height of the first insulating layer 50 is greater than a height of the second grid line 30. In this case, a solder ribbon in the first edge interconnection region 131 is prone to poor soldering with the second grid line 30 during a soldering process, resulting in the current on a portion of the second grid line 30 not being effectively collected (especially for a second grid line 30 adjacent to the first bus grid line 22, which has the greatest possibility of poor soldering). Based on this, the present application provides the first auxiliary connecting layer 80 on a portion of the second grid line 30 corresponding to the first edge interconnection region 131, so that the first insulating layer 50 is flush with the first auxiliary connecting layer 80, or a height of the first insulating layer 50 is less than a height of the first auxiliary connecting layer 80, or a height difference between the first insulating layer 50 and the first auxiliary connecting layer 80 is less than 15 µm, thereby reducing or even eliminating a risk of poor soldering, improving soldering reliability, and ensuring performance of the back-contact cell 100.

In some embodiments, in a case where the height of the first insulating layer 50 is greater than the height of the first auxiliary connecting layer 80, the height difference between the first insulating layer 50 and the first auxiliary connecting layer 80 may be 1 µm, 2 µm, 3 µm, 4 µm, 5 µm, 9 µm, 7 µm, 8 µm, 9 µm, 10 µm, 11 µm, 12 µm, 13 µm, 14 µm, 15 µm, or any value within a range of 0-15 µm.

In some embodiments, in a case where the height of the first insulating layer 50 is greater than the height of the first auxiliary connecting layer 80, the height difference between the first insulating layer 50 and the first auxiliary connecting layer 80 is preferably less than 8 µm, for example, 0.5 µm, 1 µm, 2 µm, 3 µm, 4 µm, 5 µm, 9 µm, 7 µm, or 8 µm. Specifically, through repeated research and verification by inventors of the present application, it is found that a risk of poor soldering caused by the first insulating layer 50 is substantially eliminated by preferably setting the height difference between the first insulating layer 50 and the first auxiliary connecting layer 80 within a range less than 8 µm.

In some embodiments, the first auxiliary connecting layer 80 is stacked on the second soldering segment 301 located in the first edge interconnection region 131. In a thickness direction of the back-contact cell 100, a height of the first insulating layer 50 is greater than a height of the second soldering segment 301. In this way, the provision of the first auxiliary connecting layer 80 can enhance the soldering performance between the second soldering segment 301 and the solder ribbon. As described above, in some embodiments, when the second grid line 30 is provided with a second soldering layer, the first auxiliary connecting layer 80 may be stacked on the second soldering layer.

Specifically, in such embodiments, the first auxiliary connecting layer 80 may be stacked on the second soldering segment 301. The first auxiliary connecting layer 80 may be a conductive material layer such as a solder paste layer, which is configured to solder with the solder ribbon during a soldering process. This is not specifically limited herein.

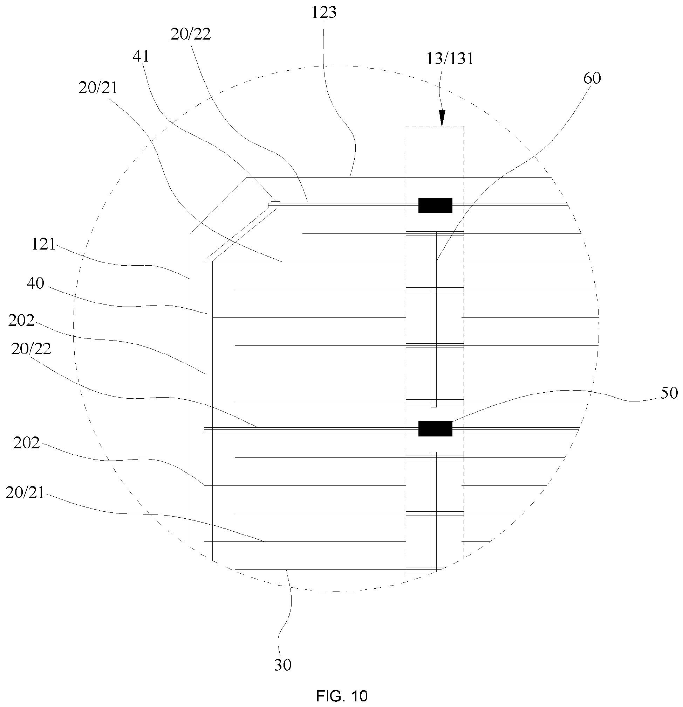

Referring to FIG. 4 and FIG. 10, in some embodiments, the substrate 10 is provided with a third edge 123 and a fourth edge 124 in the second direction. At a junction where the first grid line 20 closest to the third edge 123 is connected to the first edge bus line 40, the first edge bus line 40 is provided with a first protrusion 41 protruding toward the third edge 123.

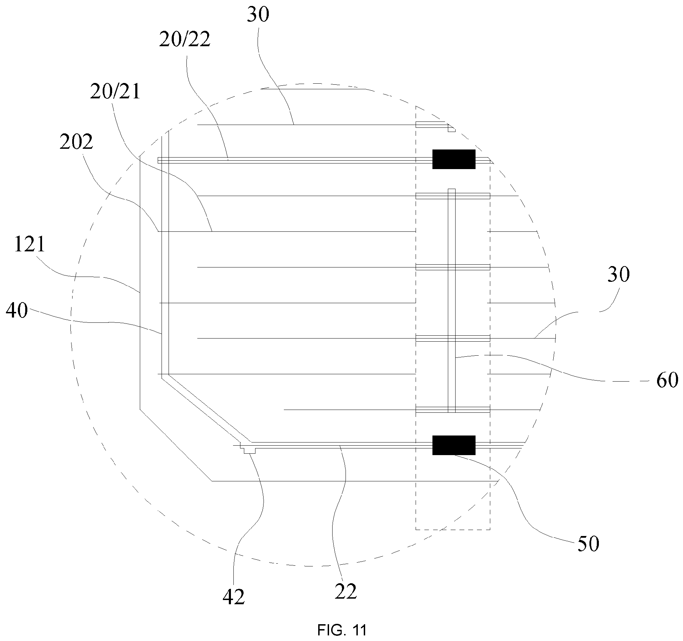

Referring to FIG. 4 and FIG. 11, in some embodiments, at a junction where the first grid line 20 closest to the fourth edge 124 is connected to the first edge bus line 40, the first edge bus line 40 is provided with a second protrusion 42 protruding toward the fourth edge 124.

In this way, the arrangement of the first protrusion 41 and the second protrusion 42 can provide redundancy for the first edge bus line 40 at corners of the back-contact cell 100 located at the first edge 121, thereby avoiding poor contact between the first edge bus line 40 and the first grid line 20 closest to the third edge 123 caused by incomplete filling of paste at the corners due to inaccurate printing during a printing process.

Specifically, in this case, in some embodiments, the first grid lines 20 closest to the third edge 123 and closest to the fourth edge 124 may be the first bus grid lines 22. In this case, when the first bus grid line 22 is provided with a first current-collecting layer 70, the first edge bus line 40 and the first current-collecting layer 70 may be integrally printed directly. At intersections between the first edge bus line 40 and the first current-collecting layer 70, the first protrusion 41 and the second protrusion 42 are provided to ensure completeness of printing filling and good contact between the first edge bus line 40 and the first current-collecting layer 70.

In addition, referring to FIG. 10 and FIG. 11, in some embodiments, in the back-contact cell 100, chamfers are formed at intersections of the first edge 121 with the third edge 123 and the fourth edge 124. At the chamfers, the first grid line 20 is provided. Therefore, as shown in FIG. 10 and FIG. 11, to achieve a connection between the first edge bus line 40 and the first grid line 20, the first edge bus line 40 is provided with bent portions at both chamfers. Of course, it can be understood that, in some embodiments, if no chamber is provided in the back-contact cell 100, there is no need to provide a bent portion.

Referring to FIG. 10 and FIG. 11, in some embodiments, at a junction between the first grid line 20 (including the first collecting grid line 21 and the first bus grid line 22) and the first edge bus line 40, at least a portion of the first grid line 20 is provided with a first grid line protrusion 202 protruding toward the first edge 121 relative to the first edge bus line 40.

In this way, by providing the first grid line protrusion 202, the stability of electrical connection between the first grid line 20 and the first edge bus line 40 can be ensured, and a situation in which a portion of the first grid line 20 fails to form stable contact with the first edge bus line 40 due to printing inaccuracies during a printing process is effectively avoided.

Referring to FIG. 3, FIG. 4, and FIG. 7, in some embodiments, a plurality of second interconnection regions 14 include a second edge interconnection region 141 closest to the first edge 121 (that is, a second interconnection region 14 adjacent to the first edge interconnection region 131). The first grid line 20 is continuous at the second edge interconnection region 141, and the second grid line 30 is discontinuous at the second edge interconnection region 141. The back-contact cell 100 further includes a second auxiliary connecting line 90. The second auxiliary connecting line 90 is provided in the second edge interconnection region 141, and in the second direction, the second auxiliary connecting line 90 is connected to the first bus grid line 22 and at least one first collecting grid line 21 located on a side of the first bus grid line 22.

In this way, by providing the second auxiliary connecting line 90 in the second edge interconnection region 141, the occurrence of poor soldering or poor contact of the solder ribbon in the second edge interconnection region 141 at the first bus grid line 22 can be effectively avoided, thereby preventing the phenomenon where current transmitted from the first bus grid line 22 cannot be collected.

Specifically, as shown in FIG. 4 and FIG. 7, in such embodiments, the number of the second auxiliary connecting lines 90 may be consistent with the number of the first bus grid lines 22, and the second auxiliary connecting lines 90 correspond one-to-one with the first bus grid lines 22. When the first bus grid line 22 is located at a middle position (i.e., first collecting grid lines 21 are provided on two sides of the first bus grid line 22), the second auxiliary connecting line 90 is connected to the first bus grid line 22 and also connected to two first collecting grid lines 21 adjacent to the first bus grid line 22 (i.e., the first collecting grid lines 21 located on two sides of and adjacent to the first bus grid line 22).

When a grid line closest to the third edge 123 is a first bus grid line 22, a first collecting grid line 21 is only provided at only one side of the first bus grid line 22. In this case, the second auxiliary connecting line 90 connected to the first bus grid line 22 at the third edge 123 is at least connected to the first collecting grid line 21 adjacent to the first bus grid line 22, and the number of first collecting grid lines 21 connected to the second auxiliary connecting line 90 is 1 to 6. For example, in FIG. 3 and FIG. 4, the second auxiliary connecting line 90 is connected to six first collecting grid lines 21 closest to the third edge 123. This is not specifically limited herein.

Similarly, when a grid line closest to the fourth edge 124 is a first bus grid line 22, a first collecting grid line 21 is only provided at only one side of the first bus grid line 22. In this case, the second auxiliary connecting line 90 connected to the first bus grid line 22 at the fourth edge 124 is at least connected to the first collecting grid line 21 adjacent to the first bus grid line 22, and the number of first collecting grid lines 21 connected to the second auxiliary connecting line 90 is 1 to 6. For example, in FIG. 3 and FIG. 4, the second auxiliary connecting line 90 is connected to six first collecting grid lines 21 closest to the fourth edge 124. This is not specifically limited herein.

In some embodiments, the width of the second auxiliary connecting line 90 (i.e., the length in the first direction) may be greater than the width of the portions of the first collecting grid lines 21 located outside the second interconnection region 14 (i.e., the portions of the first collecting grid lines 21 excluding the first soldering segments 201) (i.e., the length in the second direction). In this way, since the second auxiliary connecting line 90 functions to transmit and collect current when poor soldering occurs at the first bus grid line 22, increasing the width of the second auxiliary connecting line 90 can also reduce transmission loss during current collection process, thereby improving efficiency.

In some embodiments, the distance between the first edge interconnection region 131 and the first edge 121 is greater than or equal to 2 mm and less than or equal to 20 mm.

In this way, the distance between the first edge interconnection region 131 and the first edge 121 that is excessively small can be avoided, thereby preventing a soldering position from being excessively close to the first edge 121 and causing microcracks in the back-contact cell 100, and reducing the risk of microcracks. The distance between the first edge interconnection region 131 and the first edge 121 that is excessively large can also be avoided, thereby preventing excessive loss caused by an excessively long transmission path due to an excessively long length of an isolated grid line segment substantially located between the first edge interconnection region 131 and the first edge 121.

Specifically, in such embodiments, the distance between the first edge interconnection region 131 and the first edge 121 may be, for example, 2 mm, 3 mm, 4 mm, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or any value between 2 mm and 20 mm. This is not specifically limited herein.

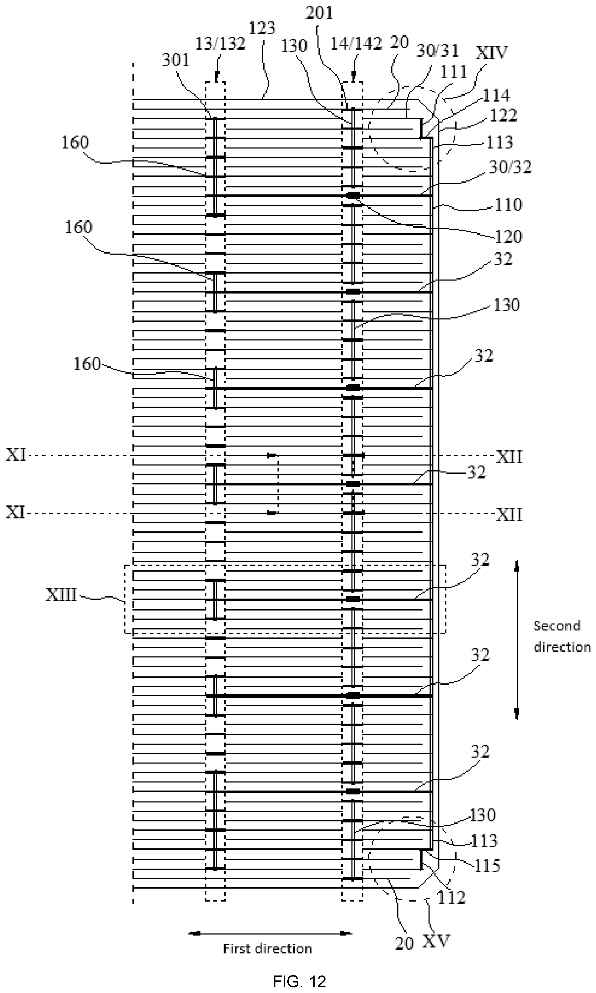

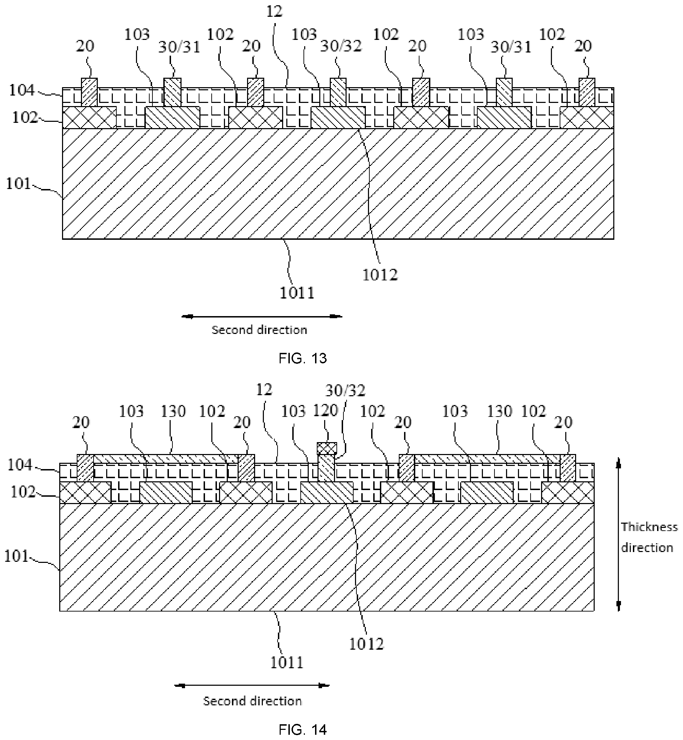

Referring to FIG. 3 and FIG. 12 to FIG. 15, in some embodiments, a plurality of second interconnection regions 14 may include a third edge interconnection region 142 closest to the second edge 122, and no first interconnection region 13 is provided between the third edge interconnection region 142 and the second edge 122. That is, as shown in FIG. 3 and FIG. 12, among the first interconnection region 13 and the second interconnection region 14, an interconnection region closest to the second edge 122 is the second interconnection region 14, and the second interconnection region 14 is denoted as the third edge interconnection region 142, where no other interconnection region is provided between the third edge interconnection region 142 and the second edge 122.

A plurality of second grid lines 30 include a plurality of second collecting grid lines 31 and at least one second bus grid line 32, where the second collecting grid line 31 is discontinuous at the third edge interconnection region 142 and continuous at the first interconnection region 13, and the second bus grid line 32 is continuous at the third edge interconnection region 142, and the first grid line 20 is continuous at the second edge interconnection region 141.

That is, the second grid lines 30 include at least two types of grid lines: the second collecting grid line 31 and the second bus grid line 32. The second collecting grid line 31 is discontinuous at the third edge interconnection region 142, the second bus grid line 32 is continuous at the third edge interconnection region 142, and the first grid line 20 is continuous at the third edge interconnection region 142.

The back-contact cell 100 further includes a second edge bus line 110 and a second insulating layer 120.

The second edge bus line 110 is closer to the second edge 122 than the third edge interconnection region 142. The second edge bus line 110 is electrically connected to at least a portion of the second collecting grid lines 31 and to the second bus grid line 32. Specifically, to avoid soldering at the edge position of the second edge 122, which would cause microcracks in the cell, the second edge bus line 110 is not used for soldering. The second edge bus line 110 is configured to collect current from a portion of the second collecting grid line 31 located between the third edge interconnection region 142 and the second edge 122, and then conduct the current through the second bus grid line 32 to the same-polarity solder ribbons in the first interconnection region 14 adjacent to the third edge interconnection region 142 (i.e., the rightmost first interconnection region 14 in FIG. 3 and FIG. 12). In this way, the current in the grid line segments of the second grid lines 30 in the edge region at the second edge 122 is collected, thereby improving the efficiency of the back-contact cell 100. Without the second edge bus line 110 and the second bus grid line 32, the portion of the second grid lines 30 located between the third edge interconnection region 142 and the second edge 122 would form isolated grid line segments, and consequently, the current in this portion cannot be collected.

The second insulating layer 120 is disposed in the third edge interconnection region 142 and located on the second bus grid line 32. That is, the second insulating layer 120 is provided on the portion of the second bus grid line 32 corresponding to the third edge interconnection region 142. The second insulating layer 120 is configured to electrically insulate the opposite-polarity solder ribbons in the third edge interconnection region 142 from the second bus grid line 32 to prevent short circuits.

In this way, by providing the second edge bus line 110 and the second bus grid line 32, the current collected from at least a portion of the isolated segments of the first grid lines 20 located between the third edge interconnection region 142 and the second edge 122 can be conducted to the same-polarity solder ribbons in the first interconnection region 13 adjacent to the third edge interconnection region 142. This arrangement effectively avoids soldering at the second edge 122 of the back-contact cell 100, which could cause microcracks, and ensures the efficiency of the back-contact cell 100. The provision of the second insulating layer 120 electrically isolates the second bus grid line 32 from the opposite-polarity solder ribbons in the third edge interconnection region 142, thereby preventing short circuits and leakage that could affect the performance of the back-contact cell 100.

It is readily understood that, in the present application, the second edge bus line 110 is not used for soldering, but only for current transmission and collection, and the second bus grid lines 32 function to collect and transmit current. It can be seen from FIG. 3 and FIG. 12 that, in the examples shown in FIG. 3 and FIG. 12, without the second edge bus line 110 and the second bus grid line 32, the second grid line 30 is discontinuous at the third edge interconnection region 142, and the current in the portion of the grid line segments of the second grid lines 30 located between the third edge interconnection region 142 and the second edge 122 cannot be collected. Therefore, by providing the second edge bus line 110 and the second bus grid line 32, the current of at least a portion of the isolated grid line segments of the second grid lines 30 in this edge region can be transmitted to the solder ribbons in the adjacent first interconnection region 13, thereby effectively preventing efficiency loss.

Referring to FIG. 3 to FIG. 6, in some embodiments, the back-contact cell 100 may further include a third auxiliary connecting line 130. The third auxiliary connecting line 130 may be disposed in the third edge interconnection region 142. In the second direction, at least one side of the second bus grid line 32 is provided with the third auxiliary connecting line 130. The third auxiliary connecting line 130 is configured to connect at least two first grid lines 20 located on the same side of the second bus grid line 32. In some embodiments, the at least two first grid lines 20 connected to the third auxiliary connecting line 130 preferably include the first grid line 20 adjacent to the second bus grid line 32 (i.e., the first grid line 20 closest to the second bus grid line 32 in FIG. 3 and FIG. 12). That is, in some embodiments, the third auxiliary connecting line 130 is preferably connected to the first grid line 20 closest to the second bus grid line 32, and the third auxiliary connecting line 130 is further connected to at least one of the remaining first grid lines 20 located on the same side as the second grid line 30. That is, the third auxiliary connecting line 130 is preferably connected to at least the first grid line 20 adjacent to the second bus grid line 32 and at least one of the remaining first grid lines 20 on the same side.

In this way, by providing the third auxiliary connecting line 130, even if poor soldering occurs between the first grid line 20 near the second insulating layer 120 and the solder ribbons due to the provision of the second insulating layer 120, with the provision of the third auxiliary connecting line 130, the first grid line 20 with poor soldering can still achieve current collection and output through the third auxiliary connecting line 130. This reduces the effect caused by poor soldering, thereby ensuring the efficiency of the back-contact cell 100.

It can be understood that, due to the continuous arrangement of the second bus grid line 32 in the third edge interconnection region 142, to prevent the solder ribbons in the third edge interconnection region 142 from contacting the second bus grid line 32 and causing short circuits, a second insulating layer 120 (for example, an insulating adhesive) needs to be provided at a position of the second bus grid line 32 corresponding to the third edge interconnection region 142. The height of the second insulating layer 120 is greater than the height of the first grid line 20, that is, in the thickness direction, the protruding height of the insulating layer is greater than the height of the first grid line 20. In this case, the solder ribbons in the third edge interconnection region 142 are prone to poor soldering with the first grid line 20 during the soldering process, which can result in ineffective current collection from the first grid lines 20 (particularly the first grid line 20 adjacent to the second bus grid line 32, which has the highest possibility of poor soldering). Based on this, the present application provides a third auxiliary connecting line 130 to connect at least two first grid lines 20 on the same side of the second bus grid line 32, preferably including the first grid line 20 adjacent to the second bus grid line 32. The third auxiliary connecting line 130 can integrate a portion of the first grid lines 20 into a single electrical network, so that even if one of the first grid lines 20 experiences poor soldering due to the presence of the second insulating layer 120, the current can still be output through the third auxiliary connecting line 130, thereby reducing or even completely eliminating the effect caused by poor soldering.

Referring to FIG. 3 and FIG. 12, in some embodiments, the back-contact cell 100 may be a busbar-free back-contact cell. Among a plurality of second grid lines 30, the second collecting grid line 31 is discontinuous at the second interconnection region 14 and continuous at the first interconnection region 13, and the second bus grid line 32 is continuous at the third edge interconnection region 142 and discontinuous at the remaining second interconnection regions 14, and is continuous at the first interconnection region 13.

As shown in FIG. 3 and FIG. 12, in an embodiment of the present application, to minimize the effect of poor soldering, when the first grid lines 20 are provided on two sides of the second bus grid line 32, third auxiliary connecting lines 130 are preferably provided on both sides of the second bus grid line 32 simultaneously.

In some embodiments, the second grid line 30 includes a second soldering segment 301, the structure of which has been described above and will not be repeated herein. In some embodiments, in the second collecting grid line 31, the width of the second soldering segments 301 (i.e., the length in the second direction) may be greater than the width of the remaining portions. In this way, the contact area between the second collecting grid lines 31 and the solder ribbons can be increased, thereby improving the stability of soldering.

In some embodiments, the width of the second bus grid line 32 (i.e., the length in the second direction) is greater than the width of the portions of the second collecting grid line 31 located outside the first interconnection region 13 (i.e., the portions of the second collecting grid line 31 excluding the second soldering segment 301) (i.e., the length in the second direction).

In this way, since the second bus grid line 32 needs to perform the function of current collection and transmission, increasing the width of the second bus grid line 32 can reduce transmission loss during current collection process, thereby improving efficiency.

In addition, in an embodiment of the present application, the second bus grid line 32 is continuous only in the third edge interconnection region 142 and discontinuous at other second interconnection regions 14. Meanwhile, the second bus grid line 32 is continuous at the first interconnection region 13 and has the second soldering segment 301 in the first interconnection region 13. Only a portion of the second bus grid line 32 closest to the first edge 121 performs the current collection function. Therefore, in some embodiments, to save paste to reduce cost, only the portion of the grid line segments may be configured to have a greater width. In this case, referring to FIG. 3, FIG. 12, and FIG. 15, the plurality of first interconnection regions 13 may include a fourth edge interconnection region 132 closest to the second edge 122. The second bus grid line 32 may include a second bus segment 321 located between the fourth edge interconnection region 132 and the first edge 121. The width of the second bus segment 321 (i.e., a length in the second direction) is greater than the width of a portion in the remaining portions of the second bus grid line 32 located outside the first interconnection region 13 (i.e., a portion of the second bus grid line 32 excluding the second bus segment 321 and the second soldering segment 301).

In this way, by configuring only the second bus segment 321 to have a greater width, transmission loss during current collection can be reduced, and the use of paste is decreased, thereby lowering costs.

Specifically, as described above, in such embodiments, the second bus grid line 32 is continuous at the fourth edge interconnection region 132 and is provided with the second soldering segment 301 in the fourth edge interconnection region 132. The second bus segment 321 is configured to collect current and conduct the current to the solder ribbons disposed in the fourth edge interconnection region 132, and configuring only a portion of the bus segment 321 to have a greater width can reduce the use of paste. In this case, the second bus segment 321 penetrates the rear passivation layer 104 and is in contact with the second doped layers 103.

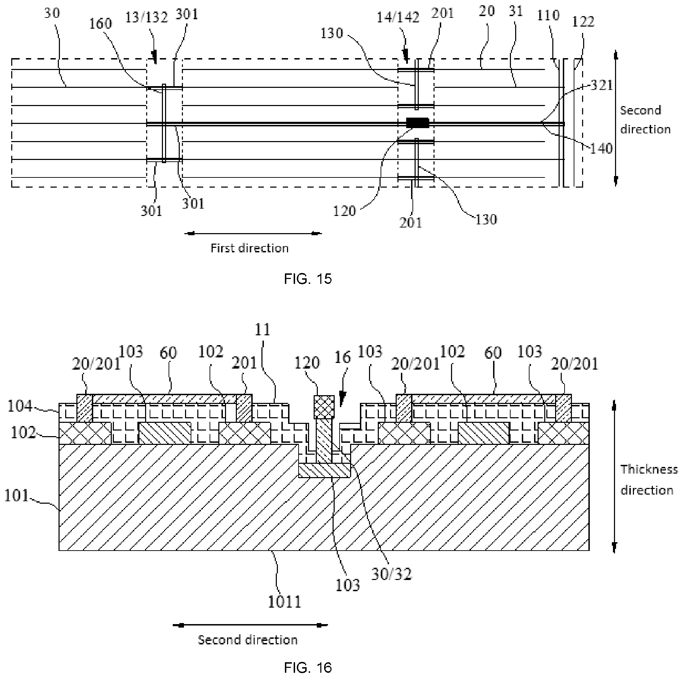

Referring to FIG. 15, in some other embodiments, a second current-collecting layer 140 may be disposed on the second bus segment 321. In this way, by providing the second current-collecting layer 140 on the second bus segment 321, the cross-sectional area of the second bus segment 321 is effectively increased, which can likewise reduce transmission loss. Meanwhile, the second current-collecting layer 140 may be formed of a paste having a lower cost than that used for the second bus segment 321, thereby reducing overall cost.

Specifically, in such embodiments, the second current-collecting layer 140 may be made of a non-fire-through paste. The second current-collecting layer 140 does not penetrate the rear passivation layer 104 to contact the first doped layer 102, and the paste cost of the second current-collecting layer 140 is lower than that of the second bus segment 321. It can be understood that, since the second current-collecting layer 140 is disposed on the second bus segment 321, there may be no need to widen the second bus segment 321, and transmission loss reduction can still be achieved.

Further, in such embodiments, the width of the second current-collecting layer 140 (i.e., the length in the second direction) may be greater than the width of the portions of the second collecting grid lines 31 located outside the first interconnection region 13 (i.e., the portions of the second collecting grid lines 31 excluding the second soldering segments 301). In this manner, by increasing the width of the second current-collecting layer 140, the current transmission capability can be further enhanced, and transmission loss can be reduced.

Specifically, in such embodiments, the width of the second current-collecting layer 140 may be the same as the second of the first soldering segment 301. Herein, the width of the second soldering segment 301 refers to the length of the second soldering segment 301 in the second direction. As described above, when the width of the second soldering layer is greater than that of the second collecting layer, the width of the second soldering segment 301 corresponds to the width of the second soldering layer (i.e., the length in the second direction). Similar descriptions appearing hereinafter may be understood with reference to this explanation. Herein, the width of the second soldering segment 301 may be the same as the width of the first soldering segment 201.

In this way, no substantial transmission loss occurs during the current collection process. Meanwhile, during the printing process, the second current-collecting layer 140 may be printed simultaneously with the first soldering layer. When the same screen is used for printing, there is no need to provide screen openings of different sizes on the screen plate, thereby simplifying the manufacturing process and reducing manufacturing difficulty.

Referring to FIG. 15, in some embodiments, the width of the second edge bus line 110 (i.e., the length in the first direction) is greater than the width of the portions of the second collecting grid line 31 located outside the first interconnection region 13 (i.e., the portions of the second collecting grid line 31 excluding the second soldering segment 301) (i.e., the length in the second direction).

In this way, since the second edge bus line 110 needs to perform the function of current collection and transmission, increasing the width of the second edge bus line 110 can also reduce transmission loss during current collection process, thereby improving efficiency.

Specifically, in such embodiments, the width of the second edge bus line 110 may be the same as the width of the second soldering segment 301. In this way, no substantial current collection loss occurs during the current-collecting process. Meanwhile, during printing, the first edge bus line 40, the first collecting grid lines 21, and the first soldering segments 201 may be printed simultaneously using the same screen plate openings, thereby effectively saving manufacturing steps and reducing manufacturing difficulty.

In addition, referring to FIG. 15, in some embodiments, the width of the third auxiliary connecting line 130 (i.e., the length in the first direction) is greater than the width of the portions of the second collecting grid line 31 located outside the first interconnection region 13 (i.e., the portions of the second collecting grid line 31 excluding the second soldering segment 301) (i.e., the length in the second direction).

In this way, since the third auxiliary connecting line 130 serves to transmit and collect current when poor soldering occurs, increasing the width of the third auxiliary connecting line 130 can also reduce transmission loss during current collection process, thereby improving efficiency.

In some embodiments, the width of the third auxiliary connecting line 130 may be the same as that of the second edge bus line 110.

Referring to FIG. 3 and FIG. 12, in some embodiments, the second edge bus line 110 is electrically connected to all the second collecting grid lines 31. In this way, the current collected by all isolated grid line segments of the second collecting grid lines 31 located between the third edge interconnection region 142 and the second edge 122 can be collected, thereby maximizing the efficiency of the back-contact cell 100.

Of course, in some embodiments, the second edge bus line 110 may also be electrically connected to a portion of the second collecting grid lines 31. In this case, the number of second collecting grid lines 31 not electrically connected to the second edge bus line 110 is less than or equal to 4. In this way, the small number of second collecting grid lines 31 not connected to the second edge bus line 110 does not cause significant efficiency loss or result in product defects.

In some embodiments, the third auxiliary connecting line 130 is connected to 2-20 first grid lines 20. In this way, setting the number of first grid lines 20 connected to the third auxiliary connecting line 130 within this reasonable range can minimize or even eliminate the effect caused by poor soldering.

In an embodiment of the present application, one second bus grid line 32 may be provided. In this case, the third auxiliary connecting line 130 may be provided on only one side of the second bus grid line 32, or the third auxiliary connecting line 130 is provided on two sides of the second bus grid line 32. This is not specifically limited herein. When the first grid lines 20 are provided on two sides of the second bus grid line 32, the third auxiliary connecting line 130 is preferably provided on two sides.

In addition, it should be noted that, in the present application, when a plurality of second bus grid lines 32 are provided, the third auxiliary connecting line 130 may be provided on only one side or on two sides of some second bus grid lines 32, and the third auxiliary connecting lines 130 may be not provided at the two sides of the remaining second bus grid lines 32. In this case, poor soldering at certain positions can still be resolved. In the present application, third auxiliary connecting lines 130 are preferably provided at two sides of each second bus grid line 32.

Of course, referring to FIG. 3 and FIG. 15, in some embodiments, a plurality of second bus grid lines 32 may be provided. With the provision of the plurality of second bus grid lines 32, a current collection path is shortened, transmission loss during current collection is effectively reduced, and the efficiency is improved.

In this case, a third auxiliary connecting line 130 is provided between each two adjacent second bus grid lines 32, and the third auxiliary connecting line 130 located between two adjacent second bus grid lines 32 is connected to all first grid lines 20 located between the two adjacent second bus grid lines 32.

In this way, the third auxiliary connecting line 130 is connected to all first grid lines 20 between two adjacent second bus grid lines 32, so that the effect caused by poor soldering is substantially eliminated, and the efficiency of the back-contact cell 100 is improved as much as possible.

Of course, in some alternative embodiments, the third auxiliary connecting line 130 may be provided only on one side of the second bus grid line 32. This is not specifically limited herein.

Specifically, in such embodiments, the number of second bus grid lines 32 in the back-contact cell 100 may be selected according to an actual condition, including a size of a cell and a loss during a transmission process. This is not specifically limited herein.

Referring to FIG. 3, FIG. 12, FIG. 18, and FIG. 19, in some embodiments, a plurality of second bus grid lines 32 are provided, and the substrate 10 is provided with a third edge 123 and a fourth edge 124 in a second direction. Among the second grid lines 30 and the first grid lines 20, a grid line closest to the third edge 123 may be a first grid line 20. The third auxiliary connecting line 130 between the second bus grid line 32 closest to the third edge 123 and the third edge 123 is connected to all the first grid lines 20 located between the second bus grid line 32 closest to the third edge 123 and the third edge 123.

Among the second grid lines 30 and the first grid lines 20, a grid line closest to the fourth edge 124 may also be a first grid line 20. The third auxiliary connecting line 130 between the second bus grid line 32 closest to the fourth edge 124 and the fourth edge 124 is connected to all the first grid lines 20 located between the second bus grid line 32 closest to the fourth edge 124 and the fourth edge 124.

Thus, by configuring the third auxiliary connecting line 130 between the second bus grid line 32 closest to the third edge 123 and the third edge 123 as described above, the effect of poor soldering caused by the second insulating layer 120 can also be substantially eliminated.

Referring to FIG. 15 and FIG. 16, as described above, in some embodiments, the first grid line 20 may include a first soldering segment 201 corresponding to the second interconnection region 14, and the second grid line 30 may include a second soldering segment 301 corresponding to the first edge interconnection region 131.

In some embodiments, a second recess 16 is formed on the substrate 10 in the third edge interconnection region 142, and a portion of the second bus grid line 32 is located in the second recess 16. In some embodiments, in the second direction, the second bus grid line 32 may extend along one side wall of the second recess 16 to a bottom of the second recess 16 and extend out from another side wall of the second recess 16 to a region outside the second recess 16. A portion of the second bus grid line 32 corresponding to the second recess 16 does not fill the entire second recess 16. That is, in a thickness direction of the back-contact cell 100, a height of the portion of the second bus grid line 32 corresponding to the second recess 16 is less than a height of an opening of the second recess 16.

As shown in FIG. 16, the second insulating layer 120 is provided at the second recess 16 in the third edge interconnection region 142, and the second insulating layer 120 is at least partially disposed in the second recess 16 and located on the second bus grid line 32. That is, the second insulating layer 120 is provided on a portion of the second bus grid line 32 located in the second recess 16, the second insulating layer 120 is at least partially located in the second recess 16, and the second insulating layer 120 is configured to insulate an opposite-polarity solder ribbon in the third edge interconnection region 142 from the second bus grid line 32 to avoid short circuits.

In a thickness direction of the back-contact cell 100 (that is, in a direction from the front side 11 toward the rear side 12), a height of the second insulating layer 120 is flush with a height of the first soldering segment 201, or the height of the second insulating layer 120 is less than the height of the first soldering segment 201, or the height of the second insulating layer 120 is greater than the height of the first soldering segment 201, and a height difference between the second insulating layer 120 and the first soldering segment 201 is less than or equal to 15 µm.

In this way, by forming a second recess 16 on the substrate 10 and disposing at least a portion of the second insulating layer 120 within the second recess 16, the height of the second insulating layer 120 may be less than the height of the first soldering segment 201, or the second insulating layer 120 may be flush with the first soldering segment 201, or the height of the second insulating layer 120 may be greater than the height of the first soldering segment 201 with a height difference therebetween being less than or equal to 15 µm. In this way, the height difference between the second insulating layer 120 and the soldering segment of the grid line can be reduced or even eliminated, thereby reducing the risk of poor soldering caused by the second insulating layer 120, further reducing the impact of poor soldering on the back-contact cell 100, and improving the performance of the back-contact cell 100.

It is readily understood that, since the second bus grid line 32 is continuously disposed in the third edge interconnection region 142, to prevent short circuits caused by contact between the solder ribbon in the third edge interconnection region 142 and the second bus grid line 32, a second insulating layer 120 (for example, an insulating adhesive) needs to be disposed at a position of the second bus grid line 32 corresponding to the third edge interconnection region 142. However, in this case, when the second recess 16 is not formed, the height of the second insulating layer 120 is greater than the height of the first soldering segment 201 of the second grid line 30. That is, in a thickness direction, a protruding height of the second insulating layer 120 is higher than the height of the first soldering segment 201 of the second grid line 30. In this case, during a soldering process, the solder ribbon in the third edge interconnection region 142 is prone to poor soldering with the second grid line 30, resulting in current on a portion of the second grid lines 30 not being effectively collected (particularly the second grid line 30 adjacent to the second bus grid line 32, which has the highest possibility of poor soldering). Based on this, the present application provides a second recess 16 on the substrate 10 and disposes at least a portion of the second insulating layer 120 within the second recess 16, such that the second insulating layer 120 is flush with the first soldering segment 201 or is lower than the first soldering segment 201, or such that a height difference between the second insulating layer 120 and the first soldering segment 201 is less than 15 µm, thereby reducing or even eliminating the risk of poor soldering, improving soldering reliability, and ensuring the performance of the back-contact cell 100.

Further, in some embodiments, a plurality of second bus grid lines 32 may be provided, the number of the second insulating layers 120 corresponds to the number of second bus grid lines 32, and the number of the second recesses 16 may correspond to the number of the second insulating layers 120. In this way, a risk of poor soldering caused by all the second insulating layers 120 is reduced or even eliminated. Of course, in some possible embodiments, the second recess 16 is provided corresponding to only some of the second bus grid lines 32. That is, the second recess 16 is formed below only some of the second insulating layers 120, and no second recess 16 is formed at other positions. In this case, the poor soldering caused by some of the second insulating layers 120 is solved.

In a case where the height of the second insulating layer 120 is greater than the height of the first soldering segment 201, the height difference between the second insulating layer 120 and the first soldering segment 201 may be 1 µm, 2 µm, 3 µm, 4 µm, 5 µm, 9 µm, 7 µm, 8 µm, 9 µm, 10 µm, 11 µm, 12 µm, 13 µm, 14 µm, 15 µm, or any value within a range of 0-15 µm.

In some embodiments, in a case where the height of the second insulating layer 120 is greater than the height of the first soldering segment 201, the height difference between the second insulating layer 120 and the first soldering segment 201 is preferably less than 8 µm, for example, 0.5 µm, 1 µm, 2 µm, 3 µm, 4 µm, 5 µm, 9 µm, 7 µm, or 8 µm. Specifically, through repeated research and verification by inventors of the present application, it is found that a risk of poor soldering caused by the second insulating layer 120 is substantially eliminated by preferably setting the height difference between the second insulating layer 120 and the first soldering segment 201 within a range less than 8 µm.

In some embodiments, a recessed depth of the second recess 16 is less than one-half of a thickness of the substrate 10. Specifically, the term "recessed depth" refers to a distance between a bottom surface of the second recess 16 and an outermost surface of the rear passivation layer 104 facing away from the rear side 12 in the thickness direction, that is, a distance between the bottom surface of the second recess 16 and the rear side 12 of the substrate 10.

In this way, by setting the depth of the second recess 16 within this reasonable range, a risk of poor soldering caused by the second insulating layer 120 is reduced or even eliminated, and a reduction in strength of the back-contact cell 100 caused by an excessively large recessed depth is avoided.

Specifically, in this case, a recessed depth of the second recess 16 may be, for example, one-third, one-fourth, or one-fifth of a thickness of the substrate 10.

In some embodiments, the second recess 16 may penetrate the rear passivation layer 104 and the second doped layer 103, so that the silicon substrate 101 is exposed at the second recess 16, and a portion of the first bus grid line 22 located in the second recess 16 is in contact with the silicon substrate 101. In this way, after the substrate 10 is fabricated, the second recess 16 may be directly formed on the substrate 10 by etching (for example, laser etching) without inserting an etching or grooving process during fabrication of the substrate 10.

Specifically, in this case, a complete substrate 10 is first provided, a grooving process is directly performed at a position on the substrate 10 where the second insulating layer 120 needs to be provided, the first grid line 20 and the second grid line 30 are then printed, and the second insulating layer 120 is provided at the second recess 16.

Of course, in some other embodiments, at a position of the first bus grid line 22 corresponding to the first edge interconnection region 131, a second recessed groove is formed on the silicon substrate 101, and both the second doped layer 103 and the rear passivation layer 104 are recessed toward a side facing the front side 11 at the second recessed groove, thereby forming the second recess 16 on the substrate 10.

Specifically, in this case, during the fabrication process, before forming the second doped layer 103, a second recessed groove may first be formed in the silicon substrate 101 at a position where the second doped layer 103 needs to be formed and where the second insulating layer 120 needs to be disposed. Thereafter, the second doped layer 103 and the rear passivation layer 104 are formed to form the substrate 10. Since the second recessed groove is formed in the silicon substrate 101, the corresponding second recess 16 may be formed in the substrate 10. Subsequently, the first grid lines 20 and the second grid lines 30 are printed, and then the second insulating layer 120 is disposed at the second recess 16.

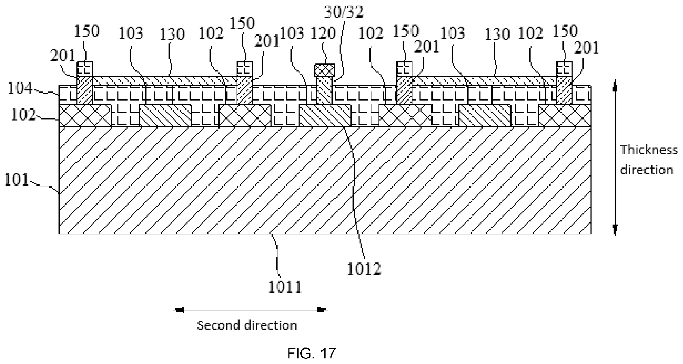

Referring to FIG. 17, in some embodiments, the back-contact cell 100 may further include a second auxiliary connecting layer 150. At the third edge interconnection region 142, the second auxiliary connecting layer 150 is disposed on the first grid line 20, that is, the second auxiliary connecting layer 150 is disposed on a portion of the first grid line 20 corresponding to the third edge interconnection region 142. The second auxiliary connecting layer 150 is configured to solder to a solder ribbon. In a thickness direction of the back-contact cell 100, the second insulating layer 120 is flush with the second auxiliary connecting layer 150, or a height of the second insulating layer 120 is less than a height of the second auxiliary connecting layer 150, or a height difference between the second insulating layer 120 and the second auxiliary connecting layer 150 is less than or equal to 15 µm.

In this way, by providing the second auxiliary connecting layer 150 on a portion of the second grid line 30 corresponding to the third edge interconnection region 142, the height of the second insulating layer 120 is less than the height of the second auxiliary connecting layer 150, or the second insulating layer 120 is flush with the second auxiliary connecting layer 150, or the height of the second insulating layer 120 is greater than the height of the second auxiliary connecting layer 150, and a height difference between the second insulating layer 120 and the second auxiliary connecting layer 150 is less than or equal to 15 µm, thereby reducing or even eliminating poor soldering caused by provision of the second insulating layer 120, reducing the impact of poor soldering on the back-contact cell 100, and improving performance and efficiency of the back-contact cell 100.

It is readily understood that, due to continuous arrangement of the second bus grid line 32 in the third edge interconnection region 142, to avoid contact between a solder ribbon on the third edge interconnection region 142 and the second bus grid line 32 that would cause short circuits, the second insulating layer 120 (for example, insulating adhesive) needs to be provided at a position of the second bus grid line 32 corresponding to the third edge interconnection region 142. However, in this case, when the second auxiliary connecting layer 150 is not provided, a height of the second insulating layer 120 is greater than a height of a portion of the second grid line 30 located in the third edge interconnection region 142, that is, in a thickness direction, a protruding height of the second insulating layer 120 is greater than a height of the second grid line 30. In this case, a solder ribbon in the third edge interconnection region 142 is prone to poor soldering with the second grid line 30 during a soldering process, resulting in the current on a portion of the second grid line 30 not being effectively collected (especially for a second grid line 30 adjacent to the second bus grid line 32, which has the greatest possibility of poor soldering). Based on this, the present application provides the second auxiliary connecting layer 150 on a portion of the second grid line 30 corresponding to the third edge interconnection region 142, so that the second insulating layer 120 is flush with the second auxiliary connecting layer 150, or a height of the second insulating layer 120 is less than a height of the second auxiliary connecting layer 150, or a height difference between the second insulating layer 120 and the second auxiliary connecting layer 150 is less than 15 µm, thereby reducing or even eliminating a risk of poor soldering, improving soldering reliability, and ensuring performance of the back-contact cell 100.

In some embodiments, in a case where the height of the second insulating layer 120 is greater than the height of the second auxiliary connecting layer 150, the height difference between the second insulating layer 120 and the second auxiliary connecting layer 150 may be 1 µm, 2 µm, 3 µm, 4 µm, 5 µm, 9 µm, 7 µm, 8 µm, 9 µm, 10 µm, 11 µm, 12 µm, 13 µm, 14 µm, 15 µm, or any value within a range of 0-15 µm.

In some embodiments, in a case where the height of the second insulating layer 120 is greater than the height of the second auxiliary connecting layer 150, the height difference between the second insulating layer 120 and the second auxiliary connecting layer 150 is preferably less than 8 µm, for example, 0.5 µm, 1 µm, 2 µm, 3 µm, 4 µm, 5 µm, 9 µm, 7 µm, or 8 µm. Specifically, through repeated research and verification by inventors of the present application, it is found that a risk of poor soldering caused by the second insulating layer 120 is substantially eliminated by preferably setting the height difference between the second insulating layer 120 and the second auxiliary connecting layer 150 within a range less than 8 µm.

In some embodiments, the second auxiliary connecting layer 150 is stacked on the first soldering segment 201 located in the third edge interconnection region 142. In a thickness direction of the back-contact cell 100, a height of the second insulating layer 120 is greater than a height of the first soldering segment 201. In this way, the provision of the second auxiliary connecting layer 150 can enhance the soldering performance between the first soldering segment 201 and the solder ribbon.

Further, as described above, in some embodiments, the specific structure of the first grid line 20 may include a second collecting layer and a second soldering layer. Details are not repeated herein. In such embodiments, the second auxiliary connecting layer 150 may be stacked on top of the first soldering layer.

Specifically, in such embodiments, the second auxiliary connecting layer 150 may be stacked on the first soldering segment 201. The second auxiliary connecting layer 150 may be a conductive material layer such as a solder paste layer, which is configured to solder with the solder ribbon during a soldering process. This is not specifically limited herein.

Referring to FIG. 12, FIG. 18, and FIG. 19, in some embodiments, the second edge bus line 110 may include a middle bus segment 113, a first edge bus segment 111, and a second edge bus segment 112. The middle bus segment 113, the first edge bus segment 111, and the second edge bus segment 112 all extend along the second direction. As shown in FIG. 12, the three segments may be arranged in parallel with intervals along the first direction. The middle bus segment 113 is positioned closer to the second edge 122 than the first edge bus segment 111 and the second edge bus segment 112.

The first edge bus segment 111 is positioned closer to the third edge 123, and the second edge bus segment 112 is positioned closer to the fourth edge 124. The second edge bus line 110 further includes a first connecting segment 114 and a second connecting segment 115, with both the first connecting segment 114 and the second connecting segment 115 extending along the first direction. The first connecting segment 114 is connected to the middle bus segment 113 and the first edge bus segment 111, and the second connecting segment 115 is connected to the middle bus segment 113 and the second edge bus segment 112.

The first edge bus segment 111 is connected to two second grid lines 30 closest to the third edge 123. At the junction of the first edge bus segment 111 and the first connecting segment 114, the first edge bus segment 111 is provided with a third protrusion 1101 that protrudes towards the fourth edge 124, and the first connecting segment 114 is provided with a fourth protrusion 1102 that protrudes towards the first edge 121. At the junction of the middle bus segment 113 and the first connecting segment 114, the middle bus segment 113 is provided with a fifth protrusion 1103 that protrudes towards the third edge 123, and the first connecting segment 114 is provided with a sixth protrusion 1104 that protrudes towards the second edge 122; and/or
the second edge bus segment 112 is connected to two second grid lines 30 closest to the fourth edge 124. At the junction of the second edge bus segment 112 and the second connecting segment 115, the second edge bus segment 112 is provided with a seventh protrusion 1105 that protrudes towards the third edge 123, and the second connecting segment 115 is provided with an eighth protrusion 1106 that protrudes towards the first edge 121. At the junction of the middle bus segment 113 and the second connecting segment 115, the middle bus segment 113 is provided with a ninth protrusion 1107 that protrudes towards the fourth edge 124, and the second connecting segment 115 is provided with a tenth protrusion 1108 that protrudes towards the second edge 122.

In this way, when a chamfer is provided at the junction of the second edge 122 with the third edge 123 and the fourth edge 124, by configuring the second edge bus line 110 as a structure of 3 vertical segments and 2 horizontal segments, the chamfer can be bypassed, thereby reducing printing difficulty. Meanwhile, by providing corresponding protrusions at the junctions of the bus segments, redundancy can be introduced at the corners of the second edge 122. This helps to prevent imprecise printing during the process, which could otherwise lead to incomplete filling of the paste at the corners, causing poor contact between the various bus segments.

Of course, it can be understood that, in some embodiments, when a chamfer is formed at the intersection of the second edge 122 with the third edge 123 and the fourth edge 124, the arrangement of the second edge bus line 110 may also be configured in the same manner as the first edge bus line 40 (for example, with the provision of a bent portion). This is not specifically limited herein. Of course, it can be understood that, in some embodiments, if the back-contact cell 100 does not include a chamfer, only one second edge bus line 110 extending continuously in a vertical direction along the second direction is provided.

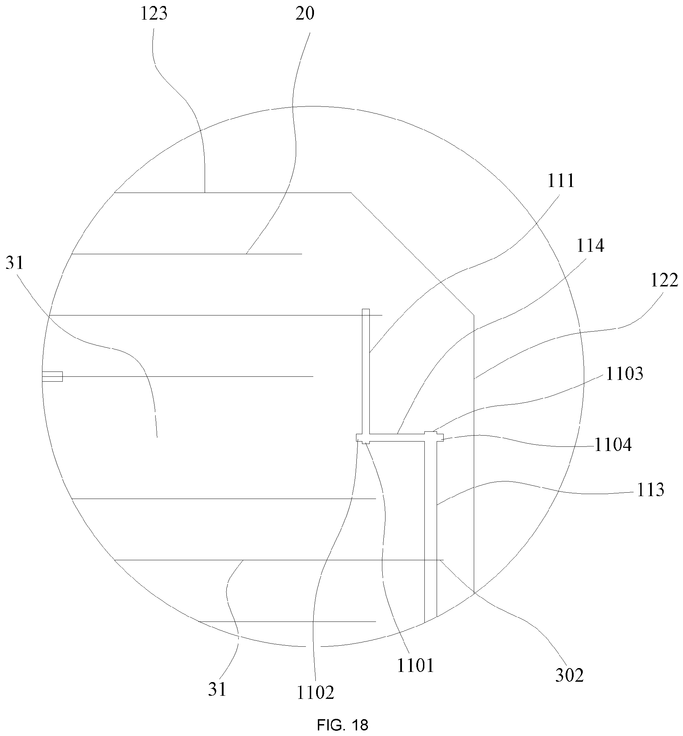

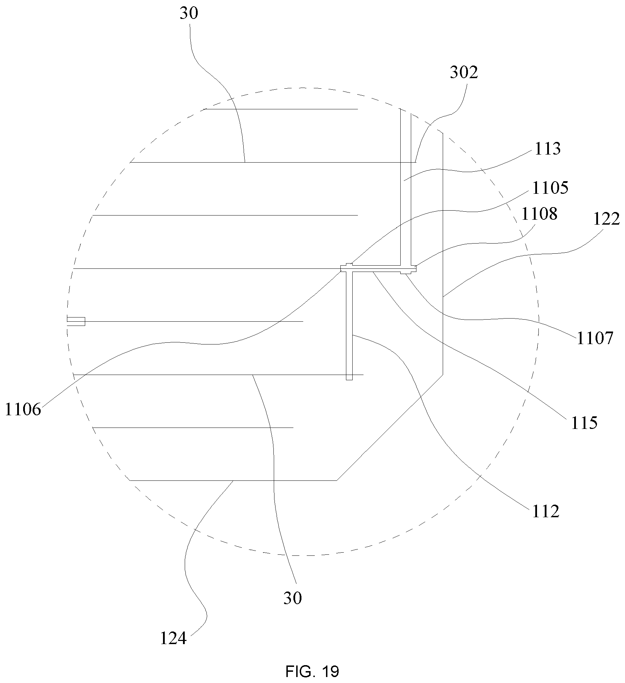

Referring to FIG. 18 and FIG. 19, in some embodiments, at the junction of the second grid line 30 (including the second collecting grid line 31 and the second bus grid line 32) and the second edge bus line 110, at least a portion of the second grid line 30 is provided with a second grid line protrusion 302 that protrudes towards the first edge 121 relative to the second edge bus line 110.

In this way, by providing the second grid line protrusion 302, the stability of electrical connection between the second grid line 30 and the second edge bus line 110 can be ensured, and a situation in which a portion of the second grid line 30 fails to form stable contact with the second edge bus line 110 due to printing inaccuracies during a printing process is effectively avoided.

Referring to FIG. 3, FIG. 12, and FIG. 15, in some embodiments, the plurality of first interconnection regions 13 may further include a fourth edge interconnection region 132 closest to the second edge 122 (i.e., the first interconnection region 13 adjacent to the third edge interconnection region 142). The second grid line 30 is continuous at the fourth edge interconnection region 132, and the first grid line 20 is discontinuous at the fourth edge interconnection region 132. The back-contact cell 100 may further include a fourth auxiliary connecting line 160, and the fourth auxiliary connecting line 160 is disposed within the fourth edge interconnection region 132. In the second direction, the fourth auxiliary connecting line 160 is connected to the second bus grid line 32 and at least one second collecting grid line 31 located on the side of the second bus grid line 32.

In this way, by providing the fourth auxiliary connecting line 160 within the fourth edge interconnection region 132, the occurrence of poor soldering or poor contact of the solder ribbon in the fourth edge interconnection region 132 at the second bus grid line 32 can be effectively avoided, thereby preventing the phenomenon where the current transmitted from the second bus grid line 32 cannot be collected.

Specifically, as shown in FIG. 12 and FIG. 15, in such embodiments, the number of the fourth auxiliary connecting lines 160 may be consistent with the number of the second bus grid lines 32, and the fourth auxiliary connecting lines 160 correspond one-to-one with the second bus grid lines 32. When the second bus grid line 32 is located at a middle position (i.e., second collecting grid lines 31 are provided on two sides of the second bus grid line 32), the fourth auxiliary connecting line is connected to the second bus grid line 32 and also connected to two second collecting grid lines 31 adjacent to the second bus grid line 32 (i.e., the second collecting grid lines 31 located on two sides of and adjacent to the second bus grid line 32).

In some embodiments, the width of the fourth auxiliary connecting line 160 (the length in the first direction) is greater than the width of the portions of the second collecting grid lines 31 located outside the first interconnection region 13 (i.e., the portions of the second collecting grid lines 31 excluding the second soldering segment 301) (the length in the second direction). In this way, since the fourth auxiliary connecting line 160 functions to transmit and collect current when poor soldering occurs at the second bus grid line 32, increasing the width of the fourth auxiliary connecting line 160 can also reduce transmission loss during current collection process, thereby improving efficiency.

In some embodiments, the distance between the third edge interconnection region 142 and the second edge 122 is greater than or equal to 2 mm and less than or equal to 20 mm.

In this way, the distance between the third edge interconnection region 142 and the second edge 122 that is excessively small can be avoided, thereby preventing a soldering position from being excessively close to the second edge 122 and causing microcracks in the back-contact cell 100, and reducing the risk of microcracks. The distance between the third edge interconnection region 142 and the second edge 122 that is excessively large can also be avoided, thereby preventing excessive loss caused by an excessively long transmission path due to an excessively long length of an isolated grid line segment substantially located between the third edge interconnection region 142 and the second edge 122.

Specifically, in such embodiments, the distance between the third edge interconnection region 142 and the second edge 122 may be, for example, 2 mm, 3 mm, 4 mm, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or any value between 2 mm and 20 mm. This is not specifically limited herein.

In the above embodiments, a polarity of the third edge interconnection region 142 is opposite to a polarity of the first edge interconnection region 131, and structures of two edges of the back-contact cell 100 in the first direction are different and asymmetric. It can be understood that, in some possible embodiments, the polarity of the third edge interconnection region 142 may also be the same as the polarity of the first edge interconnection region 131. In this case, the structures of the two edges of the back-contact cell 100 in the first direction are the same and symmetric. That is, in this case, in the back-contact cell 100, two interconnection regions closest to the second edge 122 are symmetric with the first edge interconnection region 131 and the second edge interconnection region 141. Structures such as bus lines and auxiliary connecting lines are also disposed on one side of the second edge 122, and are completely symmetric with one side of the first edge 121. For brevity, specific structures are not described in detail herein.

Referring to FIG. 3, in some embodiments, the substrate 10 is provided with a third edge 123 and a fourth edge 124 in the second direction. The first interconnection region 13 is further provided with a fifth auxiliary connecting line 170 and a sixth auxiliary connecting line 180. The fifth auxiliary connecting line 170 is connected to N second grid lines 30 closest to the third edge 123, and the sixth auxiliary connecting line 180 is connected to M second grid lines 30 closest to the fourth edge 124, where N and M are both greater than or equal to 2 and less than or equal to 8.

In some embodiments, the second interconnection region 14 is provided with a seventh auxiliary connecting line 190 and an eighth auxiliary connecting line 1100. The seventh auxiliary connecting line 190 is connected to P first grid lines closest to the third edge, and the eighth auxiliary connecting line 1100 is connected to Q first grid lines closest to the fourth edge, where P and Q are both greater than or equal to 2 and less than or equal to 8.

In this way, by respectively providing the fifth auxiliary connecting line 170 and the sixth auxiliary connecting line 180 at positions of the first interconnection region 13 close to the third edge 123 and the fourth edge 124, that is, by respectively providing the fifth auxiliary connecting line 170 and the sixth auxiliary connecting line 180 at two ends of the solder ribbon in the first interconnection region 13, poor soldering at a starting soldering point and an ending soldering point of the solder ribbon in the first interconnection region 13 can be effectively avoided, thereby preventing a problem that the current of some grid lines cannot be collected. Similarly, by respectively providing the seventh auxiliary connecting line 190 and the eighth auxiliary connecting line 1100 at positions of the second interconnection region 14 close to the third edge 123 and the fourth edge 124, that is, by respectively providing the seventh auxiliary connecting line 190 and the eighth auxiliary connecting line 1100 at two ends of the solder ribbon in the second interconnection region 14, poor soldering at partial positions of a starting soldering point and an ending soldering point of the solder ribbon in the second interconnection region 14 can be effectively avoided, thereby preventing a problem that current of some grid lines cannot be collected.

Specifically, as shown in FIG. 3, in some embodiments, the fifth auxiliary connecting line 170 in the first edge interconnection region 131 may be an integrated common structure with the first auxiliary connecting line 60 closest to the third edge 123 in the first edge interconnection region 131, and the sixth auxiliary connecting line 180 in the first edge interconnection region 131 may be an integrated common structure with the first auxiliary connecting line 60 closest to the fourth edge 124 in the first edge interconnection region 131.

The seventh auxiliary connecting line 190 in the second edge interconnection region 141 may be an integrated common structure with the second auxiliary connecting line 90 closest to the third edge 123 in the second edge interconnection region 141, and the eighth auxiliary connecting line 1100 in the second edge interconnection region 141 may be an integrated common structure with the second auxiliary connecting line 90 closest to the fourth edge 124 in the second edge interconnection region 141.

The seventh auxiliary connecting line 190 in the third edge interconnection region 142 may be an integrated common structure with the third auxiliary connecting line 130 closest to the third edge 123 in the third edge interconnection region 142, and the eighth auxiliary connecting line 1100 in the third edge interconnection region 142 may be an integrated common structure with the third auxiliary connecting line 130 closest to the fourth edge 124 in the third edge interconnection region 142.

The fifth auxiliary connecting line 170 in the fourth edge interconnection region 132 may be an integrated common structure with the fourth auxiliary connecting line 160 closest to the third edge 123 in the fourth edge interconnection region 132, and the sixth auxiliary connecting line 180 in the fourth edge interconnection region 132 may be an integrated common structure with the fourth auxiliary connecting line 160 closest to the fourth edge 124 in the fourth edge interconnection region 132.

For the first interconnection region 13 and the second interconnection region 14 located between the second edge interconnection region 141 and the fourth edge interconnection region 132, only corresponding auxiliary connecting lines need to be provided at edge-corresponding positions.

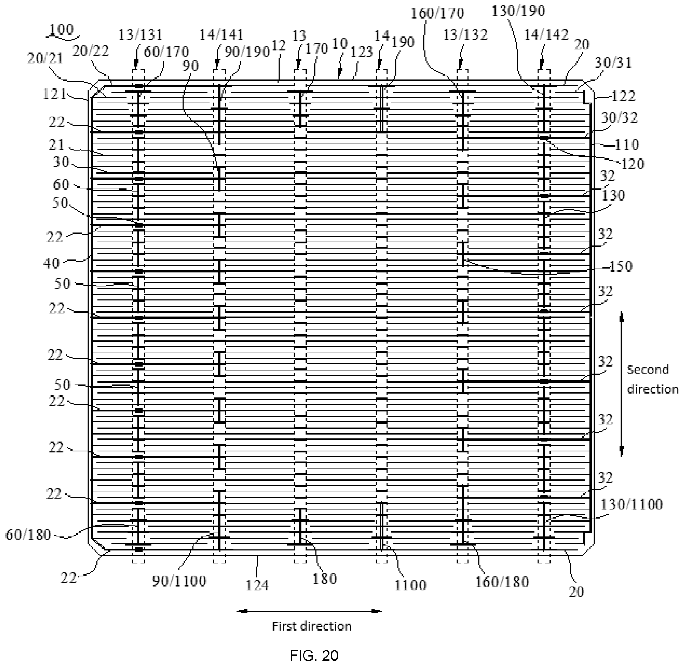

Referring to FIG. 20, in some embodiments, in the first interconnection region 13, X first grid lines 20 closest to the third edge 123 are discontinuous at the first interconnection region 13, and Y first grid lines 20 closest to the fourth edge 124 are discontinuous at the first interconnection region 13. A width of the discontinuous region formed by the X first grid lines 20 closest to the third edge 123 gradually increases in a direction toward the third edge 123, and a width of the discontinuous region formed by the Y first grid lines 20 closest to the fourth edge 124 gradually increases in a direction toward the fourth edge 124, where X and Y are both greater than or equal to 2. That is, in such embodiments, in at least two second grid lines 30 closest to the third edge 123 in the first interconnection region 13, a length of the second soldering segment 301 in the second direction on a second grid line 30 closer to the third edge 123 is greater. In at least two second grid lines 30 closest to the fourth edge 124, a length of the second soldering segment 301 in the second direction on a second grid line 30 closer to the fourth edge 124 is greater.

In the second interconnection region 14, W second grid lines 30 closest to the third edge 123 are discontinuous at the second interconnection region 14, and Z second grid lines 30 closest to the fourth edge 124 are discontinuous at the second interconnection region 14. A width of the discontinuous region formed by the W second grid lines 30 closest to the third edge 123 gradually increases in a direction toward the third edge 123, and a width of the discontinuous region formed by the Z second grid lines 30 closest to the fourth edge 124 gradually increases in a direction toward the fourth edge 124, where W and Z are both greater than or equal to 2. That is, in such embodiments, in at least two first grid lines 20 closest to the third edge 123 in the second interconnection region 14, a length of the first soldering segment 201 in the second direction on a first grid line 20 closer to the third edge 123 is greater. In at least two first grid lines 20 closest to the fourth edge 124, a length of the first soldering segment 201 in the second direction on a first grid line 20 closer to the fourth edge 124 is greater.

In this way, by configuring the discontinuous regions of the grid lines at two ends of the solder ribbon to gradually increase toward the edges, a situation in which the solder ribbon at the two ends is prone to large displacement during a soldering process, thereby contacting grid lines of opposite polarity, can be effectively avoided, which ensures reliability and stability of the soldering.

In the description of the specification, the reference terms "some embodiments", "illustrative embodiments", "examples", "specific examples", or "some examples" refer to the specific features, structures, materials, or characteristics described in conjunction with embodiments or examples included in at least one embodiment or example of the present application. The schematic expressions of the above terms in the specification do not necessarily refer to the same embodiments or examples. Moreover, the specific features, structures, materials, or characteristics described can be combined in a suitable manner in any one or more embodiments or examples.

In addition, the above are only preferred embodiments of the present application and are not intended to limit the present application. Any modifications, equivalent substitutions, and improvements made within the spirit and principles of the present application shall be included in the scope of protection of the present application.

## Claims

1. A back-contact cell, comprising:
a substrate, wherein the substrate is provided with a front side and a rear side opposite to each other, the rear side is provided with a first edge and a second edge opposite to each other in a first direction, the rear side is provided with a plurality of first interconnection regions and a plurality of second interconnection regions, the first interconnection regions and the second interconnection regions are alternately arranged in the first direction, the plurality of first interconnection regions comprise a first edge interconnection region closest to the first edge, and no second interconnection region is provided between the first edge interconnection region and the first edge;
a plurality of first grid lines and a plurality of second grid lines alternately arranged on the rear side in a second direction, wherein the second direction intersects the first direction, all the first grid lines and all the second grid lines are arranged to intersect the first interconnection regions and the second interconnection regions, the plurality of first grid lines comprise a plurality of first collecting grid lines and at least one first bus grid line, the first collecting grid line is discontinuous at the first edge interconnection region and continuous at the second interconnection region, the first bus grid line is continuous at the first edge interconnection region and in the second interconnection region, and the second grid line is continuous at the first edge interconnection region;
a first edge bus line, wherein the first edge bus line is closer to the first edge relative to the first edge interconnection region, the first edge bus line is electrically connected to at least a portion of the first collecting grid lines and electrically connected to the first bus grid line; and
a first insulating layer, wherein the first insulating layer is disposed in the first edge interconnection region and located on the first bus grid line.
Independent claim of Chinese Patent Application No. 202510107200.5:

2. The back-contact cell according to claim 1, wherein the back-contact cell further comprises a first auxiliary connecting line disposed in the first edge interconnection region, the first auxiliary connecting line is disposed on at least one side of the first bus grid line in the second direction, the first auxiliary connecting line connects at least two second grid lines located on the same side as the first bus grid line, and the at least two second grid lines connected to the first auxiliary connecting line comprise second grid line adjacent to the first bus grid line.

3. The back-contact cell according to claim 2, wherein a plurality of first bus grid lines are provided, the first auxiliary connecting line is disposed between each two adjacent first bus grid lines, and the first auxiliary connecting line between two adjacent first bus grid lines is connected to all the second grid lines located between the two adjacent first bus grid lines.

4. The back-contact cell according to claim 2, wherein a width of the first auxiliary connecting line is greater than a width of a portion of the first collecting grid line located outside the second interconnection region.

5. The back-contact cell according to claim 2, wherein a plurality of first bus grid lines are provided, and the substrate is provided with a third edge and a fourth edge in the second direction;
among the first grid lines and the second grid lines, a grid line closest to the third edge is the first collecting grid line, and a first auxiliary connecting line between a first bus grid line closest to the third edge and the third edge is connected to all second grid lines between the first bus grid line closest to the third edge and the third edge; and/or
among the first grid lines and the second grid lines, a grid line closest to the fourth edge is the first collecting grid line, and a first auxiliary connecting line between a first bus grid line closest to the fourth edge and the fourth edge is connected to all second grid lines between the first bus grid line closest to the fourth edge and the fourth edge.

6. The back-contact cell according to claim 1, wherein the first edge bus line is electrically connected to all the first collecting grid lines; or
the first edge bus line is electrically connected to a portion of the first collecting grid lines, and a number of the first collecting grid lines not electrically connected to the first edge bus line is less than or equal to 4.

7. The back-contact cell according to claim 2, wherein the first auxiliary connecting line is connected to 2-20 second grid lines.

8. The back-contact cell according to claim 1, wherein a plurality of first bus grid lines are provided, and the substrate is provided with a third edge and a fourth edge in the second direction; and
among the first grid lines and the second grid lines, a grid line closest to the third edge is the first bus grid line, and/or a grid line closest to the fourth edge is the first bus grid line.

9. The back-contact cell according to claim 1, wherein the substrate is provided with a third edge and a fourth edge in the second direction;
at a junction where a first grid line closest to the third edge is connected to the first edge bus line, the first edge bus line is provided with a first protrusion protruding toward the third edge; and/or
at a junction where a first grid line closest to the fourth edge is connected to the first edge bus line, the first edge bus line is provided with a second protrusion protruding toward the fourth edge.

10. The back-contact cell according to claim 1, wherein a width of the first bus grid line is greater than a width of a portion of the first collecting grid line located outside the second interconnection region.

11. The back-contact cell according to claim 1, wherein the plurality of second interconnection regions comprise a second edge interconnection region closest to the first edge; the first bus grid line comprises a first bus segment located between the second edge interconnection region and the first edge;
a width of the first bus segment is greater than a width of the remaining portions of the first bus grid line located outside the second interconnection region; and/or
a first current-collecting layer is disposed on the first bus segment.

12. The back-contact cell according to claim 11, wherein a width of the current-collecting layer is greater than a width of a portion of the first collecting grid line located outside the second interconnection region.

13. The back-contact cell according to claim 1, wherein a width of the first edge bus line is greater than a width of a portion of the first collecting grid line located outside the second interconnection region.

14. The back-contact cell according to claim 1, wherein the plurality of second interconnection regions comprise a second edge interconnection region closest to the first edge, the first grid line is continuous at the second edge interconnection region, the second grid line is discontinuous at the second edge interconnection region, the back-contact cell further comprises a second auxiliary connecting line, the second auxiliary connecting line is disposed in the second edge interconnection region, and in the second direction, the second auxiliary connecting line is connected to the first bus grid line and at least one first collecting grid line located on a side of the first bus grid line.

15. The back-contact cell according to claim 14, wherein a width of the second auxiliary connecting line is greater than a width of a portion of the first collecting grid line located outside the second interconnection region.

16. The back-contact cell according to claim 1, wherein a distance between the first edge interconnection region and the first edge is greater than or equal to 2 mm and less than or equal to 20 mm.
Independent claim of Chinese Patent Application No. 202510107379.4:

17. The back-contact cell according to claim 1, wherein the back-contact cell further comprises a first auxiliary connecting layer, the first auxiliary connecting layer is disposed on a portion of the second grid line located in the first edge interconnection region, and the first auxiliary connecting layer is configured to solder to a solder ribbon; and
in a thickness direction of the back-contact cell, a height of the first insulating layer is flush with a height of the first auxiliary connecting layer, or the height of the first insulating layer is less than the height of the first auxiliary connecting layer, or the height of the first insulating layer is greater than the height of the first auxiliary connecting layer, and a height difference between the first insulating layer and the first auxiliary connecting layer is less than or equal to 15 µm.

18. The back-contact cell according to claim 17, wherein the first grid line comprises a first soldering segment located in the second interconnection region, and the second grid line comprises a second soldering segment located in the first interconnection region; and
the first auxiliary connecting layer is stacked on the second soldering segment located in the first edge interconnection region, and in the thickness direction of the back-contact cell, a height of the first insulating layer is greater than a height of the second soldering segment.

19. The back-contact cell according to claim 17, wherein the first grid line comprises a first collecting layer and a first soldering layer, the first collecting layer is continuous at the second interconnection region and discontinuous at the first interconnection region, and the first soldering layer is disposed at the second interconnection region and located on the first collecting layer; or
the first collecting layer is discontinuous at both the second interconnection region and the first interconnection region, and the first soldering layer is disposed at the second interconnection region and is electrically connected to two ends formed by the first collecting layer at the second interconnection region; and
a width of the first soldering layer is greater than a width of the first collecting layer.

20. The back-contact cell according to claim 17, wherein the second grid line comprises a second collecting layer and a second soldering layer, the second collecting layer is continuous at the first interconnection region and discontinuous at the second interconnection region, and the second soldering layer is disposed at the first interconnection region and located on the second collecting layer; or the second collecting layer is discontinuous at both the first interconnection region and the second interconnection region, the second soldering layer is disposed at the first interconnection region and is electrically connected to two ends formed by the second collecting layer at the first interconnection region; and
a width of the second soldering layer is greater than a width of the second collecting layer, and the first auxiliary connecting line is disposed on the second soldering layer.

21. The back-contact cell according to claim 17, wherein the first auxiliary connecting line comprises a solder paste layer.
Independent claim of Chinese Patent Application No. 202510101742.1:

22. The back-contact cell according to claim 1, wherein the first grid line comprises a first soldering segment located in the second interconnection region, and the second grid line comprises a second soldering segment located in the first interconnection region;
in the first edge interconnection region, a first recess is formed on the substrate, a portion of the first bus grid line is located within the first recess, and the first insulating layer is at least partially disposed within the first recess and located on the first bus grid line; and
in a direction from the front side toward the rear side, a height of the first insulating layer is flush with a height of the second soldering segment, or the height of the first insulating layer is less than the height of the second soldering segment, or the height of the first insulating layer is greater than the height of the second soldering segment, and a height difference between the first insulating layer and the second soldering segment is less than or equal to 15 µm.

23. The back-contact cell according to claim 22, wherein a recessed depth of the first recess is less than one-half of a thickness of the substrate.

24. The back-contact cell according to claim 22, wherein the first insulating layer is entirely located within the first recess.

25. The back-contact cell according to claim 22, wherein the substrate comprises a silicon substrate, a plurality of first doped layers, a plurality of second doped layers, and a rear passivation layer, the silicon substrate is provided with a first surface and a second surface opposite to each other, both the first doped layers and the second doped layers are disposed on the second surface, the plurality of first doped layers and the plurality of second doped layers are alternately arranged along a second direction, the rear passivation layer is at least stacked on the first doped layers and the second doped layers, the first grid line is disposed corresponding to the first doped layers and at least partially penetrates the rear passivation layer to be in conductive contact with the first doped layers, and the second grid line is disposed corresponding to the second doped layers and at least partially penetrates the rear passivation layer to be in conductive contact with the second doped layers;
the first recess penetrates the rear passivation layer and the first doped layers, so that the silicon substrate is exposed from the first recess, and a portion of the first bus grid line located within the first recess contacts the silicon substrate; or
at a position of the first edge interconnection region corresponding to the first bus grid line, a first recessed groove is formed on the silicon substrate, both the first doped layers and the rear passivation layer are recessed at the first recessed groove toward a side facing the front side to form the first recess on the substrate.

26. The back-contact cell according to claim 1, wherein a plurality of the second interconnection regions comprises a third edge interconnection region closest to the second edge, and no first interconnection region is provided between the third edge interconnection region and the second edge;
the plurality of second grid lines comprise a plurality of second collecting grid lines and at least one second bus grid line, the second collecting grid lines are discontinuous at the third edge interconnection region and continuous at the first interconnection region, the second bus grid line is continuous at the third edge interconnection region and the first interconnection region, and the first grid line is continuous at the third edge interconnection region;
the back-contact cell further comprises:
a second edge bus line, wherein the second edge bus line is closer to the second edge than the third edge interconnection region, and the second edge bus line is electrically connected to at least a portion of the second collecting grid lines and electrically connected to the second bus grid line; and
a second insulating layer, wherein the second insulating layer is disposed in the third edge interconnection region and located on the second bus grid line.

27. The back-contact cell according to claim 26, wherein the back-contact cell further comprises a third auxiliary connecting line disposed within the third edge interconnection region, the third auxiliary connecting line is disposed on at least one side of the second bus grid line in the second direction, the third auxiliary connecting line is connected to at least two first grid lines located on the same side of the second bus grid line, and the at least two first grid lines connected to the third auxiliary connecting line comprise first grid lines adjacent to the second bus grid line.

28. The back-contact cell according to claim 27, wherein a plurality of second bus grid lines are provided, the third auxiliary connecting line is disposed between each two adjacent second bus grid lines, and the third auxiliary connecting line located between each two adjacent second bus grid lines is connected to all the first grid lines located between the two adjacent second bus grid lines.

29. The back-contact cell according to claim 27, wherein a width of the third auxiliary connecting line is greater than a width of the second collecting grid line.

30. The back-contact cell according to claim 27, wherein a plurality of second bus grid lines are provided, and the substrate is provided with a third edge and a fourth edge in the second direction; and
among the first grid lines and the second grid lines, a grid line closest to the third edge is a first grid line, and a third auxiliary connecting line located between a second bus grid line closest to the third edge and the third edge is connected to all first grid lines between the second bus grid line closest to the third edge and the third edge; and/or
among the first grid lines and the second grid lines, a grid line closest to the fourth edge is a first grid line, and a third auxiliary connecting line located between a second bus grid line closest to the fourth edge and the fourth edge is connected to all first grid lines between the second bus grid line closest to the fourth edge and the fourth edge.

31. The back-contact cell according to claim 26, wherein the second edge bus line is electrically connected to all the second collecting grid lines; or
the second edge bus line is electrically connected to a portion of the second collecting grid lines, and a number of the second collecting grid lines not electrically connected to the second edge bus line is less than or equal to 4.

32. The back-contact cell according to claim 27, wherein the third auxiliary connecting line is connected to 2-20 first grid lines.

33. The back-contact cell according to claim 26, wherein the substrate is provided with a third edge and a fourth edge in the second direction, the second edge bus line comprises a middle bus segment, a first edge bus segment, and a second edge bus segment, the middle bus segment, the first edge bus segment, and the second edge bus segment each extend along the second direction, the middle bus segment is closer to the second edge than the first edge bus segment and the second edge bus segment, the first edge bus segment is disposed close to the third edge, and the second edge bus segment is disposed close to the fourth edge;
the second edge bus line further comprises a first connecting segment and a second connecting segment, both the first connecting segment and the second connecting segment extend along the first direction, the first connecting segment is connected to the middle bus segment and the first edge bus segment, and the second connecting segment is connected to the middle bus segment and the second edge bus segment;
the first edge bus segment is connected to two second grid lines closest to the third edge, at a junction between the first edge bus segment and the first connecting segment, the first edge bus segment is provided with a third protrusion protruding toward the fourth edge, the first connecting segment is provided with a fourth protrusion protruding toward the first edge, at a junction between the middle bus segment and the first connecting segment, the middle bus segment is provided with a fifth protrusion protruding toward the third edge, and the first connecting segment is provided with a sixth protrusion protruding toward the second edge; and/or
the second edge bus segment is connected to two second grid lines closest to the fourth edge, at a junction between the second edge bus segment and the second connecting segment, the second edge bus segment is provided with a seventh protrusion protruding toward the third edge, the second connecting segment is provided with an eighth protrusion protruding toward the first edge, at a junction between the middle bus segment and the second connecting segment, the middle bus segment is provided with a ninth protrusion protruding toward the fourth edge, and the second connecting segment is provided with a tenth protrusion protruding toward the second edge.

34. The back-contact cell according to claim 26, wherein a width of the second bus grid line is greater than a width of a portion of the second collecting grid line located outside the first interconnection region.

35. The back-contact cell according to claim 26, wherein the plurality of first interconnection regions comprise a fourth edge interconnection region closest to the second edge; the second bus grid line comprises a second bus segment located between the fourth edge interconnection region and the second edge;
a width of the second bus segment is greater than a width of the remaining portion of the second bus grid line located outside the first interconnection region; and/or
a second current-collecting layer is disposed on the second bus segment.

36. The back-contact cell according to claim 35, wherein a width of the second current-collecting layer is greater than a width of a portion of the second collecting grid line located outside the first interconnection region.

37. The back-contact cell according to claim 26, wherein a width of the second edge bus line is greater than a width of a portion of the second collecting grid line located outside the first interconnection region.

38. The back-contact cell according to claim 26, wherein the plurality of first interconnection regions comprises a fourth edge interconnection region closest to the second edge, the second grid line is continuous at the fourth edge interconnection region, the first grid line is discontinuous at the fourth edge interconnection region, the back-contact cell further comprises a fourth auxiliary connecting line, the fourth auxiliary connecting line is disposed within the fourth edge interconnection region, and in the second direction, the fourth auxiliary connecting line is connected to at least one second bus grid line and at least one second collecting grid line located on a side of the second bus grid line.

39. The back-contact cell according to claim 38, wherein a width of the fourth auxiliary connecting line is greater than a width of a portion of the second collecting grid line located outside the first interconnection region.

40. The back-contact cell according to claim 26, wherein a distance between the second edge interconnection region and the second edge is greater than or equal to 2 mm and less than or equal to 20 mm.

41. The back-contact cell according to claim 26, wherein the back-contact cell further comprises a second auxiliary connecting layer, the second auxiliary connecting layer is disposed on a portion of the first grid line located in the third edge interconnection region, and the second auxiliary connecting layer is configured to solder to a solder ribbon; and
in a thickness direction of the back-contact cell, a height of the second insulating layer is flush with a height of the second auxiliary connecting layer, or the height of the second insulating layer is less than the height of the second auxiliary connecting layer, or the height of the second insulating layer is greater than the height of the second auxiliary connecting layer, and a height difference between the second insulating layer and the second auxiliary connecting layer is less than or equal to 15 µm.

42. The back-contact cell according to claim 41, wherein the first grid line comprises a first soldering segment located in the second interconnection region, and the second grid line comprises a second soldering segment located in the first interconnection region; and
the second auxiliary connecting layer is stacked on the first soldering segment located in the third edge interconnection region, and in the thickness direction of the back-contact cell, a height of the second insulating layer is greater than a height of the first soldering segment.

43. The back-contact cell according to claim 41, wherein the first grid line comprises a first collecting layer and a first soldering layer, the first collecting layer is continuous at the second interconnection region and discontinuous at the first interconnection region, and the first soldering layer is disposed at the second interconnection region and located on the first collecting layer; or
the first collecting layer is discontinuous at both the second interconnection region and the first interconnection region, and the first soldering layer is disposed at the second interconnection region and is electrically connected to two ends formed by the first collecting layer at the second interconnection region; and
a width of the first soldering layer is greater than a width of the first collecting layer, and the second auxiliary connecting line is disposed on the first soldering layer.

44. The back-contact cell according to claim 41, wherein the second auxiliary connecting line is a solder paste layer.

45. The back-contact cell according to claim 26, wherein the first grid line comprises a first soldering segment located in the second interconnection region, and the second grid line comprises a second soldering segment located in the first interconnection region;
in the third edge interconnection region, a second recess is formed on the substrate, a portion of the second bus grid line is located within the second recess, and the second insulating layer is at least partially disposed within the second recess and located on the second bus grid line; and
in a thickness direction of the back-contact cell, a height of the second insulating layer is flush with a height of the first soldering segment, or the height of the second insulating layer is less than the height of the first soldering segment, or the height of the second insulating layer is greater than the height of the first soldering segment, and a height difference between the second insulating layer and the first soldering segment is less than or equal to 15 µm.

46. The back-contact cell according to claim 45, wherein a recessed depth of the second recess is less than one-half of a thickness of the substrate.

47. The back-contact cell according to claim 45, wherein the second insulating layer is entirely located within the second recess.

48. The back-contact cell according to claim 45, wherein the substrate comprises a silicon substrate, a plurality of first doped layers, a plurality of second doped layers, and a rear passivation layer, the silicon substrate is provided with a first surface and a second surface opposite to each other, both the first doped layers and the second doped layers are disposed on the second surface, the plurality of first doped layers and the plurality of second doped layers are alternately arranged along a second direction, the rear passivation layer is at least stacked on the first doped layers and the second doped layers, the first grid line is disposed corresponding to the first doped layers and at least partially penetrates the rear passivation layer to be in conductive contact with the first doped layers, and the second grid line is disposed corresponding to the second doped layers and at least partially penetrates the rear passivation layer to be in conductive contact with the second doped layers;
the second recess penetrates the rear passivation layer and the second doped layers, so that the silicon substrate is exposed from the second recess, and a portion of the second bus grid line located within the second recess contacts the silicon substrate; or
at a position of the second edge interconnection region corresponding to the second bus grid line, a second recessed groove is formed on the silicon substrate, both the second doped layers and the rear passivation layer are recessed at the second recessed groove toward a side facing the front side to form the second recess on the substrate.

49. The back-contact cell according to claim 1, wherein the substrate is provided with a third edge and a fourth edge in the second direction, a fifth auxiliary connecting line and a sixth auxiliary connecting line are disposed in the first interconnection region, the fifth auxiliary connecting line is connected to N second grid lines closest to the third edge, the sixth auxiliary connecting line is connected to M second grid lines closest to the fourth edge, wherein N and M are each greater than or equal to 2 and less than or equal to 8; and/or
a seventh auxiliary connecting line and an eighth auxiliary connecting line are disposed in the second interconnection region, the seventh auxiliary connecting line is connected to P first grid lines closest to the third edge, the eighth auxiliary connecting line is connected to Q first grid lines closest to the fourth edge, wherein P and Q are each greater than or equal to 2 and less than or equal to 8.

50. The back-contact cell according to claim 1, wherein the substrate is provided with a third edge and a fourth edge in the second direction;
in the first interconnection region, X first grid lines closest to the third edge are discontinuous at the first interconnection region, Y first grid lines closest to the fourth edge are discontinuous at the first interconnection region, a width of a discontinuous region formed by the X first grid lines closest to the third edge gradually increases in a direction toward the third edge, and a width of a discontinuous region formed by the Y first grid lines closest to the fourth edge gradually increases in a direction toward the fourth edge, wherein X and Y are each greater than or equal to 2;
in the second interconnection region, W second grid lines closest to the third edge are discontinuous at the second interconnection region, Z second grid lines closest to the fourth edge are discontinuous at the second interconnection region, a width of a discontinuous region formed by the W second grid lines closest to the third edge gradually increases in a direction toward the third edge, and a width of a discontinuous region formed by the Z second grid lines closest to the fourth edge gradually increases in a direction toward the fourth edge, wherein W and Z are each greater than or equal to 2.

51. A cell assembly, comprising a plurality of the back-contact cells according to any one of claims 1 to 50.

52. A photovoltaic system, comprising the cell assembly according to claim 51.
